(19) **Europäisches Patentamt**
**European Patent Office**
**Office européen des brevets**

(11) **EP 4 049 445 B1**

(12) **EUROPÄISCHE PATENTSCHRIFT**

(45) Veröffentlichungstag und Bekanntmachung des Hinweises auf die Patenterteilung:
**08.11.2023 Patentblatt 2023/45**

(21) Anmeldenummer: **20781365.0**

(22) Anmeldetag: **28.09.2020**

(51) Internationale Patentklassifikation (IPC):
*H01L 27/146* (2006.01)     *H04N 23/84* (2023.01)
*H04N 25/704* (2023.01)

(52) Gemeinsame Patentklassifikation (CPC):
**H01L 27/14621; H01L 27/14609; H01L 27/14683; H04N 23/843; H04N 25/704;** H04N 23/672

(86) Internationale Anmeldenummer:
**PCT/EP2020/077140**

(87) Internationale Veröffentlichungsnummer:
**WO 2021/078473 (29.04.2021 Gazette 2021/17)**

(54) **VERFAHREN ZUR ERZEUGUNG EINES AUSGABESIGNALS EINES PDAF-BILDPUNKTS**

METHOD FOR GENERATING AN OUTPUT SIGNAL OF A PDAF PIXEL

PROCÉDÉ DE GÉNÉRATION D'UN SIGNAL DE SORTIE D'UN PIXEL PDAF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.10.2019 DE 102019128781**

(43) Veröffentlichungstag der Anmeldung:
**31.08.2022 Patentblatt 2022/35**

(73) Patentinhaber: **Leica Camera AG**
**35578 Wetzlar (DE)**

(72) Erfinder: **HOPP, Benjamin**
**35390 Gießen (DE)**

(74) Vertreter: **Manitz Finsterwald**
**Patent- und Rechtsanwaltspartnerschaft mbB**
**Martin-Greif-Strasse 1**
**80336 München (DE)**

(56) Entgegenhaltungen:
**US-A1- 2012 236 185**    **US-A1- 2014 267 839**
**US-A1- 2015 319 412**    **US-A1- 2019 098 240**

**Beschreibung**

Die vorliegende Erfindung betrifft ein Verfahren zur Erzeugung eines Ausgabesignals eines PDAF-Bildpunkts eines optoelektronischen Bildsensors und eine Sensoreinrichtung mit einem optoelektronischen Bildsensor.

Optoelektronische Bildsensoren mit PDAF-Bildpunkten (PDAF: *phase detection autofocus*) werden unter anderem in digitalen Kameras, etwa Foto- und Videokameras, eingesetzt, um eine Phasenvergleich-Autofokusfunktion bereitzustellen. Bei einem optoelektronischen Bildsensor mit integrierten PDAF-Bildpunkten sind die für den Phasenvergleich genutzten PDAF-Bildpunkte direkt auf dem Bildsensor integriert und es wird kein separater Autofokus-Sensor benötigt. Daher können Kameras mit derartigen Sensoren besonders kompakt gebaut werden, beispielsweise als spiegellose Systemkameras.

Die PDAF-Bildpunkte weisen in der Regel Blenden auf, die einen Teil der lichtempfindlichen Fläche des jeweiligen PDAF-Bildpunkts abdecken und so dafür sorgen, dass der jeweilige PDAF-Bildpunkt die aus der zu fokussierenden Optik austretende Strahlung lediglich aus einer vorgegebenen Richtung empfängt. Die PDAF-Bildpunkte sind üblicherweise in zwei Gruppen unterteilt und die PDAF-Bildpunkte der beiden Gruppen empfangen Strahlung aus unterschiedlichen Richtungen. Anhand der räumlichen Phasenverschiebung der aus den unterschiedlichen Richtungen empfangenen Bilder auf dem Bildsensor kann dann die Fokuslage der Optik bestimmt und die Optik scharfgestellt werden.

Die in den PDAF-Bildpunkten eingesetzten Blenden haben jedoch den Nachteil, dass ein Teil der auf die PDAF-Bildpunkte einfallenden Strahlung abgeschattet wird und die PDAF-Bildpunkte daher nicht die gleiche Bildinformation tragen wie gewöhnliche Bildpunkte ohne Blenden. Werden die Bildpunktsignale der PDAF-Bildpunkte daher zur Erstellung eines mittels des Bildsensors aufgenommenen Bildes verwendet, so weisen die Bilder in den die PDAF-Bildpunkte umgebenden Regionen in der Regel Bildfehler auf.

Die Druckschriften US 2014/267839 A1, US 2019/098240 A1, US 2015/319412 A1 und US 2012/236185 A1 beschreiben jeweils Korrekturverfahren zur Korrektur von Bildpunktsignalen von PDAF-Bildpunkten.

Es ist Aufgabe der Erfindung ein Verfahren zur Erzeugung eines Ausgabesignals eines PDAF-Bildpunkts eines optoelektronischen Bildsensors, sowie eine Sensoreinrichtung mit einem optoelektronischen Bildsensor derart anzugeben, dass bei der Erstellung eines durch den Bildsensor aufgenommenen Bildes Bildfehler vermieden werden.

Diese Aufgabe wird durch ein Verfahren und eine Sensoreinrichtung gemäß den unabhängigen Ansprüchen gelöst. Weiterbildungen sind jeweils in den abhängigen Ansprüchen angegeben.

Es wird ein Verfahren zur Erzeugung eines Ausgabesignals eines PDAF-Bildpunkts eines optoelektronischen Bildsensors unter Verwendung von Bildpunktsignalen von in einem Umfeld des PDAF-Bildpunkts angeordneten weiteren Bildpunkten angegeben. Der Bildsensor weist innerhalb des zur Erzeugung des Ausgabesignals herangezogenen Umfelds in einer entlang einer ersten Richtung verlaufenden Bildpunktreihe den PDAF-Bildpunkt und mindestens einen weiteren PDAF-Bildpunkt auf und das Verfahren umfasst:

- Erfassen von Bildpunktsignalen der innerhalb des Umfelds angeordneten Bildpunkte des Bildsensors,
- Bestimmen einer Strukturrichtung einer auf den Bildsensor abgebildeten Bildstruktur aus den Bildpunktsignalen zumindest eines Teils der innerhalb des Umfelds angeordneten Bildpunkte, und
- Erzeugen des Ausgabesignals des PDAF-Bildpunkts.

Das Ausgabesignal des PDAF-Bildpunkts wird dabei in einem Fall als Interpolationssignal aus den Bildpunktsignalen von innerhalb des Umfelds angeordneten weiteren Bildpunkten und in einem anderen Fall als verstärktes Signal durch Korrektur des Bildpunktsignals des PDAF-Bildpunkts mit einem Verstärkungsfaktor erzeugt, wobei das Ausgabesignal des PDAF-Bildpunkts als das verstärkte Signal erzeugt wird, falls die Strukturrichtung um weniger als einen vorgegebenen Winkel von der ersten Richtung abweicht.

Indem das Ausgabesignal des PDAF-Bildpunkts fallweise als Interpolationssignal oder als verstärktes Signal erzeugt wird, kann das eigentliche Bildsignal des PDAF-Bildpunkts, unabhängig von der Strukturrichtung der abgebildeten Bildstruktur, besonders genau rekonstruiert werden und ein aus den Bildsignalen erstelltes Bild ist im Wesentlichen frei von Bildfehlern. Das Ausgabesignal des PDAF-Bildpunkts kann insbesondere in Abhängigkeit von der bestimmten Strukturrichtung als das Interpolationssignal oder als das verstärkte Signal erzeugt werden.

Die Strukturrichtung wird dabei als diejenige Richtung bestimmt, in der die abgebildete Bildstruktur den geringsten Kontrast aufweist und entlang derer die Bildpunkte des Bildsensors folglich mit im Wesentlichen der gleichen Intensität belichtet werden. Bei einer Bestimmung des Bildsignals des PDAF-Bildpunkts mittels Interpolation werden daher dann die besten Ergebnisse erzielt, wenn die Interpolation entlang der Strukturrichtung erfolgt und das Ausgabesignal des PDAF-Bildpunkts aus entlang der Strukturrichtung um den PDAF-Bildpunkt herum angeordneten weiteren Bildpunkten des Umfelds erzeugt wird.

Verläuft die Strukturrichtung jedoch im Wesentlichen parallel zu der ersten Richtung, in der auch die PDAF-Bildpunkte nebeneinander angeordnet sind, so liefert zumindest der weitere PDAF-Bildpunkt, welcher, wie der PDAF-Bildpunkt, mit einer Blende abgeschattet ist, keine vollständige Information über die eintreffende Strahlung. Wird daher auch das Bildsignal des weiteren PDAF-Bildpunkts bei einer Interpolation verwendet, so kann es zu Bildfehlern in aus den Ausgabesignalen erstellten Bildern kommen. Indem das Ausgabesignal des PDAF-Bildpunkts dann, wenn die Strukturrichtung um weniger als den vorgegebenen Winkel von der ersten Richtung abweicht, also im Wesentlichen parallel zu der ersten Richtung ausgerichtet ist, als das verstärkte Signal und nicht als Interpolationssignal erzeugt wird, werden Bildfehler, wie sie bei einer Interpolation entlang der ersten Richtung möglich sind, vermieden.

Je nach Ausgestaltung des Bildsensors kann es neben den genannten Fällen unter Umständen auch noch andere Fälle geben, in denen das Ausgabesignal des PDAF-Bildpunkts weder als das genannte Interpolationssignal, noch als das genannte verstärkte Signal, beispielsweise durch eine Kombination aus den beiden genannten Signalen, erzeugt wird. Das Ausgabesignal des PDAF Bildpunkts kann jedoch auch lediglich auf die zwei genannten Arten erzeugt werden, nämlich entweder als das Interpolationssignal oder als das verstärkte Signal.

Die den PDAF-Bildpunkt und den weiteren PDAF-Bildpunkt umfassende Bildpunktreihe kann als PDAF-Bildpunktreihe bezeichnet werden. In der PDAF-Bildpunktreihe können neben dem PDAF-Bildpunkt einer oder mehrere der für die Erzeugung des Interpolationssignals herangezogenen weiteren Bildpunkte ebenfalls als PDAF-Bildpunkte ausgebildet sein. Alle PDAF-Bildpunkte innerhalb des Umfelds können ausschließlich in der PDAF-Bildpunktreihe, nicht jedoch in anderen Bildpunktreihen des Umfelds angeordnet sein. Bei dem Bildsensor können insbesondere all diejenigen Bildpunkte innerhalb des Umfelds, die in der PDAF-Bildpunktreihe angeordnet sind und bei einer Erzeugung des Interpolationssignals herangezogen werden würden, als PDAF-Bildpunkte ausgebildet sein, so dass eine Rekonstruktion des Ausgabesignals des PDAF-Bildpunkts mittels Interpolation entlang der PDAF-Bildpunktreihe grundsätzlich nicht möglich ist.

Der Bildsensor kann insbesondere als ein Farbsensor mit farbselektiven Bildpunkten ausgebildet sein. Beispielsweise können die farbselektiven Bildpunkte als grüne, blaue und rote Bildpunkte mit einem grünen, blauen bzw. roten Farbfilter ausgebildet sein. Die farbselektiven Bildpunkte können auf dem Bildsensor an Bildpunktpositionen angeordnet sein, die gemäß einer vorgegebenen Farbmatrix verteilt sind. Die Bildpunkte können insbesondere gemäß einer Bayer-Matrix angeordnet sein. Die einzelnen Zeilen der Bayer-Matrix umfassen abwechselnd entweder grüne und rote Bildpunktpositionen oder grüne und blaue Bildpunktpositionen. Dabei sind entlang der einzelnen Zeilen die grünen und roten bzw. die grünen und blauen Bildpunktpositionen ebenfalls abwechselnd nebeneinander angeordnet. Zusätzlich sind die grünen Bildpunktpositionen der grün/roten Zeilen gegenüber den grünen Bildpunktpositionen der grün/blauen Zeilen jeweils um eine Spalte gegeneinander verschoben, so dass die Bayer-Matrix abwechselnd Spalten mit alternierenden grünen und roten Bildpunktpositionen und Spalten mit alternierenden grünen und blauen Bildpunktpositionen aufweist.

Der Bildsensor kann aber auch als ein Monochromsensor ausgebildet sein, welcher ohne farbselektive Bildpunkte ausgeführt ist und bei dem jeder Bildpunkt im gleichen Spektralbereich lichtempfindlich ist.

Das zur Erzeugung des Ausgabesignals herangezogene Umfeld kann symmetrisch um den PDAF-Bildpunkt angeordnet sein. Es kann beispielsweise in der ersten Richtung und in einer senkrecht zu der ersten Richtung orientierten Normalenrichtung die gleiche Ausdehnung aufweisen, beispielsweise eine Ausdehnung von fünf Bildpunkten.

Bei den genannten Bildpunkten, die zur Erzeugung des Interpolationssignals herangezogen werden, kann es sich beispielsweise um alle Bildpunkte handeln, die innerhalb des Umfelds in der für die Interpolation verwendeten Richtung neben dem PDAF-Bildpunkt und auf Bildpunktpositionen der Farbmatrix des Bildsensors angeordnet sind, denen die gleiche Farbe zugeordnet ist wie der Bildpunktposition des PDAF-Bildpunkts. Beispielsweise können sich der PDAF-Bildpunkt und die zur Erzeugung des Interpolationssignals herangezogenen Bildpunkte jeweils auf grünen, roten oder insbesondere auf blauen Bildpunktpositionen befinden.

Die Interpolation kann beispielswiese entlang vorgegebener Interpolationsrichtungen erfolgen, beispielsweise entweder entlang einer senkrecht zu der ersten Richtung orientierten zweiten Richtung oder entlang gegenüber der ersten und zweiten Richtung um 45° geneigten Diagonalenrichtungen. Die Interpolation kann insbesondere unter Ausschluss der ersten Richtung erfolgen und anstelle einer Interpolation entlang der ersten Richtung kann dann die Korrektur des Bildpunktsignals des PDAF-Bildpunkts mit dem Verstärkungsfaktor erfolgen. Das Verfahren kann ein Bestimmen der für die Interpolation heranzuziehenden Interpolationsrichtung umfassen. Die jeweilige für die Interpolation herangezogene Interpolationsrichtung kann beispielsweise diejenige Richtung sein, entlang derer die für die Interpolation verwendeten weiteren Bildpunkte die geringste Bildsignaldifferenz aufweisen.

Der PDAF-Bildpunkt und der weitere PDAF-Bildpunkt können innerhalb des für die Erzeugung des Ausgabesignals herangezogenen Umfelds an Bildpunktpositionen gleicher Farbe angeordnet sein. Bei dem Bildsensor können innerhalb des für die Erzeugung des Ausgabesignals herangezogenen Umfelds insbesondere alle in der PDAF-Bildpunktreihe an Bildpunktpositionen gleicher Farbe angeordneten Bildpunkte, beispielsweise alle Bildpunkte an blauen, roten oder grünen Bildpunktpositionen, als PDAF-Bildpunkte ausgebildet sein. Dabei kann insbesondere jeder zweite Bildpunkt der PDAF-Bildpunktreihe innerhalb des Umfelds als ein PDAF-Bildpunkt ausgebildet sein, insbesondere bei einem Bildsensor mit Bayer-Matrix. Darüber hinaus können nicht nur alle innerhalb des Umfelds in der PDAF-Bildpunktreihe angeordneten Bildpunkte gleicher Farbe als PDAF-Bildpunkte ausgebildet sein, sondern auch alle außerhalb des Umfelds in der PDAF-Bildpunktreihe angeordneten Bildpunkte gleicher Farbe, beispielsweise jeder blaue und/oder jeder zweite Bildpunkt der PDAF-Bildpunktreihe.

Die Strukturrichtung kann unter Berücksichtigung lediglich derjenigen Bildpunkte innerhalb des Umfelds bestimmt werden, die als vollflächig belichtete Bildpunkte und nicht als PDAF-Bildpunkte ausgebildet sind. Die Strukturrichtung kann unter Verwendung von Bildpunkten an Bildpunktpositionen lediglich einer Farbe bestimmt werden, beispielsweise an Bildpunktpositionen mit der Farbe der Bildpunktposition des PDAF-Bildpunkts. Insbesondere kann die Strukturrichtung jedoch auch unter Verwendung von Bildpunkten, die an Bildpunktpositionen unterschiedlicher Farbe angeordnet sind, beispielsweise unter Verwendung von Bildpunkten an Bildpunktpositionen aller Farben, bestimmt werden.

Das verstärkte Signal kann erzeugt werden, indem das gesamte erfasste Bildpunktsignal des PDAF-Bildpunkts oder lediglich ein Teil des Bildpunktsignals des PDAF-Bildpunkts mit dem Verstärkungsfaktor multipliziert wird. Der Verstärkungsfaktor kann dabei dem Verhältnis aus der Gesamtfläche des PDAF-Bildpunkts zur Fläche des durch die Blende abgedunkelten Bereichs des PDAF-Bildpunkts entsprechen, bei einem halbseitig abgedeckten PDAF-Bildpunkt also einem Faktor zwei.

Alternativ kann der Verstärkungsfaktor g auch aus einem Signalverhältnis von Bildpunktsignalen vollflächig belichteter Bildpunkte zu Bildpunktsignalen von als PDAF-Bildpunkte ausgebildeten abgeschatteten Bildpunkten bestimmt werden. Beispielsweise kann der Verstärkungsfaktor g bestimmt werden zu

$$g = \frac{\sum_i y_i}{\sum_i y_{PDAF,i}}$$

wobei $y_i$ das Bildpunktsignal eines i-ten vollflächig belichteten Bildpunkts und $y_{PDAF,i}$ das Bildpunktsignal eines i-ten abgeschatteten PDAF-Bildpunkts bezeichnet. Die einzelnen Summen des Zählers und Nenners werden dabei jeweils über die gleiche Anzahl von Bildpunkten gebildet. Alternativ kann auch das Signalverhältnis aus einem Mittelwert, beispielsweise dem arithmetischen oder geometrischen Mittelwert, der Bildpunktsignale der vollflächigen Bildpunkte zu einem Mittelwert, beispielsweise dem arithmetischen oder geometrischen Mittelwert, der Bildpunktsignale der abgeschatteten PDAF-Bildpunkte bestimmt werden.

Weist der Bildsensor ein Farbfilter auf, so sind die zur Bestimmung des Signalverhältnisses herangezogenen vollflächig belichteten Bildpunkte jeweils an Bildpunktpositionen angeordnet, deren Farbe der Farbe der Bildpunktposition des PDAF-Bildpunkts, dessen Ausgabesignal erzeugt wird, entspricht. Dabei kann der PDAF-Bildpunkt selbst einen Farbfilter aufweisen, dessen Farbe der Farbe seiner Bildpunktposition entspricht oder er kann einen Farbfilter aufweisen, dessen Farbe sich von der Farbe seiner Bildpunktposition unterscheidet.

Die zur Bestimmung des Signalverhältnisses herangezogenen Bildpunkte können in einer vorgegebenen Umgebung um den PDAF-Bildpunkt, dessen Ausgabesignal erzeugt wird, angeordnet sein. Die vorgegebene Umgebung kann beispielsweise eine lokale Umgebung des PDAF-Bildpunkts sein und beispielsweise höchstens zwei weitere, höchstens vier weitere, höchstens acht weitere oder höchstens sechzehn weitere PDAF-Bildpunkte umfassen. Die vorgegebene Umgebung kann auch die komplette PDAF-Bildpunktreihe, in der der betreffende PDAF-Bildpunkt angeordnet ist, sein. Alternativ kann die vorgegebene Umgebung auch die gesamte Bildpunktfläche des Bildsensors sein.

Bei einer Weiterbildung des Verfahrens wird das Bildpunktsignal des PDAF-Bildpunkts zur Erzeugung des verstärkten Signals dadurch korrigiert, dass lediglich ein ein vorgegebenes Dunkelsignal des PDAF-Bildpunkts übersteigender Signalanteil des Bildpunktsignals des PDAF-Bildpunkts mit dem Verstärkungsfaktor skaliert wird.

Das Dunkelsignal ist dasjenige Bildsignal, welches der PDAF-Bildpunkt im unbelichteten Zustand ausgibt. Da der Wert des Dunkelsignals unabhängig von der Belichtung des PDAF-Bildpunkts ist, reproduziert das verstärkte Signal das bei einer vollflächigen Belichtung des PDAF-Bildpunkts erzeugte Signal besonders genau, wenn lediglich der belichtungsabhängige und das Dunkelsignal übersteigende Anteil des Bildsignals des PDAF-Bildpunkts mit dem Verstärkungsfaktor skaliert wird.

Das verstärkte Signal $y_{PDAF,G}$ kann insbesondere bestimmt werden zu

$$y_{PDAF,G} = (y_{PDAF} - y_0) \cdot g + y_0$$

mit dem erfassten Bildpunktsignal $y_{PDAF}$ des PDAF-Bildpunkts, dem Verstärkungsfaktor $g$ und dem Dunkelsignalanteil $y_0$.

Bei einer Weiterbildung des Verfahrens beträgt der vorgegebene Winkel mindestens 0°, mindestens 10°, mindestens 13° oder mindestens 16° und/oder höchstens 45°, höchstens 35°, höchstens 23° oder höchstens 20°, beispielsweise 14°, 18° oder 22,5°. Wird der vorgegebene Winkel zu klein gewählt, so wird das Ausgabesignal auch bei einer lediglich geringen Abweichung der Strukturrichtung von der ersten Richtung mittels Interpolation erzeugt, was insbesondere bei Ausschluss einer Interpolation entlang der ersten Richtung zu Interpolationsfehlern führen kann. Andererseits wird das Ausgabesignal bei einer zu großen Wahl des vorgegebenen Winkels auch in den Fällen, in denen eigentlich eine fehlerfreie Interpolation, beispielsweise entlang einer Diagonalenrichtung, möglich wäre, durch Korrektur des Bildsignals des PDAF-Bildpunkts mit dem Verstärkungsfaktor erzeugt, was im Vergleich zu einer Interpolation zu einer ungenaueren Reproduktion des wahren Bildsignals des PDAF-Bildpunkts führen könnte.

Bei einer Weiterbildung des Verfahren wird die Strukturrichtung aus einem ersten Kontrastwert und einem zweiten Kontrastwert der abgebildeten Bildstruktur bestimmt, wobei der erste Kontrastwert einen Kontrast der Bildstruktur entlang der ersten Richtung und der zweite Kontrastwert einen Kontrast der Bildstruktur entlang einer von der ersten Richtung verschiedenen, insbesondere entlang einer zu der ersten Richtung orthogonalen, zweiten Richtung spezifiziert. Auf diese Weise ist eine einfache und schnelle Bestimmung der Strukturrichtung möglich.

Die Strukturrichtung kann allgemein dadurch bestimmt werden, dass ein Winkel zwischen der Strukturrichtung und der ersten Richtung bestimmt wird. Die Strukturrichtung kann insbesondere aus dem Verhältnis des ersten und zweiten Kontrastwerts bestimmt werden, welches ein Maß für den Winkel zwischen der Strukturrichtung und der ersten Richtung ist. Insbesondere entspricht bei einer senkrechten Ausrichtung von erster und zweiter Richtung das Verhältnis des zweiten Kontrastwerts zu dem ersten Kontrastwert dem Kotangens des Winkels zwischen der Strukturrichtung und der ersten Richtung. Die Strukturrichtung weicht dann um weniger als den vorgegebenen Winkel von der ersten Richtung ab, wenn das Verhältnis des zweiten Kontrastwerts zu dem ersten Kontrastwert einen aus dem vorgegebenen Winkel abgeleiteten Schwellenwert überschreitet. Der abgeleitete Schwellenwert kann beispielsweise dem Kotangens des vorgegebenen Winkels entsprechen und beispielsweise 6 oder 3 oder 2,4 oder 2 betragen.

Bei einer Weiterbildung des Verfahrens wird der erste Kontrastwert unter Berücksichtigung einer Mehrzahl von ersten Bildpunktpaaren erzeugt, die jeweils zwei der weiteren Bildpunkte umfassen, die innerhalb des Umfelds in entlang der ersten Richtung verlaufenden ersten Bildpunktreihen des Bildsensors angeordnet sind. Alternativ oder zusätzlich wird der zweite Kontrastwert unter Berücksichtigung einer Mehrzahl von zweiten Bildpunktpaaren erzeugt, die jeweils zwei der weiteren Bildpunkte umfassen, die innerhalb des Umfelds in entlang der zweiten Richtung verlaufenden zweiten Bildpunktreihen des Bildsensors angeordnet sind.

Indem jeweils eine Mehrzahl erster Bildpunktpaare bzw. eine Mehrzahl zweiter Bildpunktpaare zur Bestimmung der Kontrastwerte herangezogen wird, können die Kontrastwerte besonders robust bestimmt werden, ohne dass kleinräumige Variationen der abgebildeten Bildstruktur die aus den Kontrastwerten bestimmte Strukturrichtung unverhältnismäßig stark beeinflussen würden. Der erste Kontrastwert und/oder der zweite Kontrastwert können beispielsweise als die Summe der Beträge der Differenzen der Bildpunktsignale der jeweiligen Bildpunkte der einzelnen ersten bzw. zweiten Bildpunktpaare bestimmt werden.

Die jeweiligen Bildpunkte einzelner erster Bildpunktpaare können symmetrisch um eine senkrecht zu der ersten Richtung verlaufende und den PDAF-Bildpunkt umfassende senkrechte Bildpunktreihe angeordnet sein. Die senkrechte Bildpunktreihe kann insbesondere durch eine den PDAF-Bildpunkt umfassende Bildpunktspalte des Bildsensors gebildet werden. Die jeweiligen Bildpunkte einzelner weiterer erster Bildpunktpaare können auch asymmetrisch in Bezug auf die senkrechte Bildpunktreihe angeordnet sein. Beispielsweise kann jeweils einer der Bildpunkte eines ersten Bildpunktpaares in der senkrechten Bildpunktreihe und der andere der Bildpunkte des jeweiligen ersten Bildpunktpaares in einer durch die senkrechte Bildpunktreihe begrenzten Hälfte der Umgebung, die zur Erzeugung des Ausgabesignals des PDAF-Bildpunkts herangezogen wird, angeordnet sein. Die Mehrzahl erster Bildpunktpaare kann zudem sowohl erste Bildpunktpaare umfassen, deren jeweilige Bildpunkte symmetrisch um die den PDAF-Bildpunkt umfassende senkrechte Bildpunktreihe angeordnet sind, als auch erste Bildpunktpaare, deren jeweilige Bildpunkte asymmetrisch um die den PDAF-Bildpunkt umfassende senkrechte Bildpunktreihe angeordnet sind.

Entsprechend können die jeweiligen Bildpunkte einzelner zweiter Bildpunktpaare symmetrisch um die entlang der ersten Richtung verlaufende und den PDAF-Bildpunkt umfassende PDAF-Bildpunktreihe angeordnet sein. Die jeweiligen Bildpunkte einzelner weiterer zweiter Bildpunktpaare können auch asymmetrisch in Bezug auf die PDAF-Bildpunktreihe angeordnet sein. Beispielsweise kann jeweils einer der Bildpunkte eines zweiten Bildpunktpaars in der PDAF-Bildpunktreihe und der andere der Bildpunkte des jeweiligen zweiten Bildpunktpaares in einer durch die PDAF-Bildpunktreihe begrenzten Hälfte der zur Erzeugung des Ausgabesignals des PDAF-Bildpunkts herangezogenen Umgebung angeordnet sein. Die Mehrzahl zweiter Bildpunktpaare kann zudem sowohl zweite Bildpunktpaare umfassen, deren jeweilige Bildpunkte symmetrisch um die PDAF-Bildpunktreihe angeordnet sind, als auch zweite Bildpunktpaare, deren jeweilige Bildpunkte asymmetrisch um die PDAF-Bildpunktreihe angeordnet sind.

Bei einer Weiterbildung des Verfahrens besteht jedes erste Bildpunktpaar aus zwei weiteren Bildpunkten, die jeweils die gleiche Farbe aufweisen, und/oder jedes zweite Bildpunktpaar besteht aus zwei weiteren Bildpunkten, die jeweils die gleiche Farbe aufweisen. Indem die einzelnen Bildpunktpaare jeweils Bildpunkte gleicher Farbe umfassen, können die Kontrastwerte als Summen farbspezifischer Einzelkontraste bestimmt werden, wobei die farbspezifischen Einzelkontraste jeweils durch Signaldifferenzen der gleichfarbigen Bildpunkte der einzelnen Bildpunktpaare bestimmt werden.

Bei einer Weiterbildung des Verfahrens umfasst der erste Kontrastwert eine Summe von Differenzbeträgen der Bildpunktsignale der weiteren Bildpunkte der einzelnen ersten Bildpunktpaare und/oder der zweite Kontrastwert umfasst eine Summe von Differenzbeträgen der Bildpunktsignale der weiteren Bildpunkte der einzelnen zweiten Bildpunktpaare. Die Differenzbeträge werden dabei durch die Beträge der Differenzen der Bildpunkte der einzelnen Bildpunktpaare gebildet.

Bei einer Weiterbildung des Verfahrens entspricht eine Anordnung der zweiten Bildpunktpaare einer aus der ersten Richtung um den PDAF-Bildpunkt in die zweite Richtung gedrehten Anordnung der ersten Bildpunktpaare. Insbesondere umfasst die Mehrzahl erster Bildpunktpaare und die Mehrzahl zweiter Bildpunktpaare die gleiche Anzahl an Bildpunktpaaren. Außerdem umfassen die zweiten Bildpunktpaare keinen Bildpunkt, der bei einer Drehung der Anordnung der Bildpunkte in der Umgebung des PDAF-Bildpunkts aus der zweiten Richtung in die erste Richtung auf einen PDAF-Bildpunkt, etwa den weiteren PDAF-Bildpunkt, abgebildet wird. Dadurch wird sichergestellt, dass die Signaldifferenzen der einzelnen ersten Bildpunktpaare zur Bestimmung des ersten Kontrastwerts und die Signaldifferenzen der einzelnen zweiten Bildpunktpaare zur Bestimmung des zweiten Kontrastwerts gleich gewichtet werden und bei der Bestimmung der Strukturrichtung keine Vorzugsrichtung aufgrund einer ungleichmäßigen Anzahl oder Verteilung der ersten und zweiten Bildpunktpaare gegeben ist.

Bei einer Weiterbildung des Verfahrens wird die Strukturrichtung aus den Bildpunktsignalen von Bildpunkten unterschiedlicher Farbe bestimmt. Insbesondere kann die Strukturrichtung aus den Bildpunktsignalen von Bildpunkten aller Farben bestimmt werden. Die Kontrastrichtung kann auf diese Weise besonders zuverlässig bestimmt werden. Die Strukturrichtung kann insbesondere dadurch aus den Bildpunktsignalen von Bildpunkten unterschiedlicher Farbe bestimmt werden, dass die Mehrzahl erster Bildpunktpaare und/oder die Mehrzahl zweiter Bildpunktpaare Bildpunktpaare unterschiedlicher Farbe umfasst.

Bei einer Weiterbildung des Verfahrens wird die Strukturrichtung unter Ausschluss der Bildpunktsignale des PDAF-Bildpunkts und des weiteren PDAF-Bildpunkts bestimmt. Insbesondere kann die Strukturrichtung unter Ausschluss aller in dem Umfeld enthaltenen PDAF-Bildpunkte bestimmt werden, so dass beispielsweise bei einer Bestimmung der Strukturrichtung über den ersten und zweiten Kontrastwert der PDAF-Bildpunkt und der mindestens eine weitere PDAF-Bildpunkt in keinem der ersten und/oder zweiten Bildpunktpaare enthalten sind. Aufgrund der teilweisen Abschattung der PDAF-Bildpunkte eignen sich diese nicht zur Bestimmung der Strukturrichtung, beispielsweise über den ersten und zweiten Kontrastwert. Insbesondere können die jeweiligen zur Bestimmung des ersten und zweiten Kontrastwerts herangezogenen Bildpunktpaare unter Ausschluss des PDAF-Bildpunkts und des weiteren PDAF-Bildpunkts aus benachbart angeordneten Bildpunkten gleicher Farbe gebildet werden.

Bei einer Weiterbildung des Verfahrens wird das Ausgabesignal des PDAF-Bildpunkts zumindest dann als das Interpolationssignal erzeugt, falls die Strukturrichtung senkrecht zu der ersten Richtung orientiert ist, vorzugsweise in allen Fällen, in denen die Strukturrichtung von der ersten Richtung um mehr als den vorgegebenen Winkel abweicht. Das Ausgabesignal des PDAF-Bildpunkts kann insbesondere grundsätzlich immer als das Interpolationssignal erzeugt werden, außer in den Fällen, in denen die Strukturrichtung um höchstens den vorgegebenen Winkel von der ersten Richtung abweicht.

Bei einer Weiterbildung umfasst das Verfahren ein Bestimmen mindestens zweier Signaldifferenzwerte, wobei die einzelnen Signaldifferenzwerte aus Bildpunktsignalen jeweils zweier der weiteren Bildpunkte bestimmt werden, die innerhalb des Umfelds um den PDAF-Bildpunkt in durch den PDAF-Bildpunkt verlaufenden und für die einzelnen Signaldifferenzwerte jeweils unterschiedlichen weiteren Richtungen beidseits des PDAF-Bildpunkts angeordnet sind. Außerdem wird das Interpolationssignal aus den Bildpunktsignalen derjenigen weiteren Bildpunkte, die den kleinsten Signaldifferenzwert aufweisen, erzeugt.

Die entlang der unterschiedlichen weiteren Richtungen bestimmten Signaldifferenzwerte sind jeweils ein Maß für den Kontrast der abgebildeten Bildstruktur entlang der betreffenden weiteren Richtung. Diejenige weitere Richtung, entlang derer die weiteren Bildpunkte den kleinsten Signaldifferenzwert aufweisen, entspricht dann der Richtung mit minimalem Kontrast. Daher kann davon ausgegangen werden, dass die abgebildete Bildstruktur entlang der betreffenden Richtung orientiert ist und die Belichtung des PDAF-Bildpunkts im Wesentlichen mit der gleichen Intensität erfolgt, wie bei den beiden zur Bestimmung der Signaldifferenzwerte entlang der betreffenden Richtung herangezogenen weiteren Bildpunkten. Indem das Interpolationssignal aus den Bildpunktsignalen derjenigen weiteren Bildpunkte, die den kleinsten Signaldifferenzwert aufweisen, erzeugt wird, entspricht das Interpolationssignal besonders genau demjenigen Bildsignal, welches der PDAF-Bildpunkt liefern würde, wenn er keine Blende aufweisen und vollflächig belichtet werden würde.

Die weiteren Bildpunkte, aus denen die einzelnen Signaldifferenzwerte bestimmt werden, können entlang der betreffenden weiteren Richtung entweder symmetrisch oder asymmetrisch um den PDAF-Bildpunkt herum angeordnet sein. Die weiteren Richtungen können insbesondere eine senkrecht zu der ersten Richtung orientierte Normalenrichtung und/oder gegenüber der ersten Richtung um 45° geneigte Diagonalenrichtungen umfassen.

Bei einer Weiterbildung des Verfahrens weichen die weiteren Richtungen jeweils von der ersten Richtung ab. Insbesondere erfolgt also keine Interpolation entlang der in der ersten Richtung ausgerichteten PDAF-Bildpunktreihe. Da in der PDAF-Bildpunktreihe insbesondere an den Bildpunktpositionen, welche die gleiche Farbe wie die Bildpunktposition des PDAF-Bildpunkts aufweisen, weitere PDAF-Bildpunkte angeordnet sein können, könnte das Ausgabesignal des PDAF-Bildpunkts bei einer Interpolation unter Verwendung der PDAF-Bildpunkte möglicherweise fehlerhaft erzeugt werden. Anstelle der Interpolation entlang der ersten Richtung wird das Ausgabesignal des PDAF-Bildpunkts bei dem beschriebenen Verfahren als das verstärkte Signal erzeugt.

Bei einer Weiterbildung des Verfahrens wird das Interpolationssignal als ein Mittelwert der Bildpunktsignale derjenigen weiteren Bildpunkte, die den kleinsten Signaldifferenzwert aufweisen, erzeugt, beispielsweise als ein arithmetischer oder gewichteter Mittelwert. Ein derartiger Mittelwert ist besonders einfach zu berechnen und reproduziert gleichzeitig das bei einer vollflächigen Belichtung des PDAF-Bildpunkts erzeugte Signal besonders genau. Der gewichtete Mittelwert kann beispielsweise mit den Abständen, in denen die einzelnen zur Bildung des Mittelwerts herangezogenen Bildpunkte von dem PDAF-Bildpunkt entfernt angeordnet sind, gewichtet werden.

Bei einer Weiterbildung des Verfahrens umfassen die Signaldifferenzwerte einen diagonalen Signaldifferenzwert, der aus Bildpunktsignalen zweier weiterer Bildpunkte bestimmt wird, die innerhalb des Umfelds um den PDAF-Bildpunkt in einer durch den PDAF-Bildpunkt verlaufenden Diagonalenrichtung beidseits des PDAF-Bildpunkts angeordnet sind. Indem bei der Bestimmung des Interpolationssignals auch die Diagonalenrichtung und nicht nur eine senkrecht zu der ersten Richtung orientierte weitere Richtung berücksichtigt wird, kann das Interpolationssignal das bei einer vollflächigen Belichtung des PDAF-Bildpunkts erzeugte Bildsignal besonders genau reproduzieren.

Bei einer Weiterbildung des Verfahrens wird die diagonale Signaldifferenz aus dem Bildpunktsignal zweier von dem PDAF-Bildpunkt in der Diagonalenrichtung gleich weit entfernter weiterer Bildpunkte bestimmt, wenn beide gleich weit entfernten weiteren Bildpunkte funktionsfähig sind, und die diagonale Signaldifferenz wird aus Bildpunktsignalen zweier in der Diagonalenrichtung unterschiedlich weit von dem PDAF-Bildpunkt entfernter weiterer Bildpunkte bestimmt, wenn einer der in der Diagonalenrichtung gleich weit entfernten weiteren Bildpunkte defekt ist.

Bei den zur Bestimmung der Signaldifferenz herangezogenen weiteren Bildpunkten kann es sich jeweils um Bildpunkte vorgegebener Farbe handeln. Die vorgegebene Farbe kann insbesondere die Farbe derjenigen Bildpunktposition sein, an der der PDAF-Bildpunkt angeordnet ist. Insbesondere kann es sich bei den von dem PDAF-Bildpunkt gleich weit entfernten Bildpunkten jeweils um dem PDAF-Bildpunkt in der Diagonalenrichtung nächstgelegene Bildpunkte der vorgegebenen Farbe handeln.

Die Bildpunktsignale der nächstgelegenen Bildpunkte vorgegebener Farbe weichen üblicherweise am wenigsten von dem bei einer vollflächigen Belichtung des PDAF-Bildpunkts erzeugten Bildsignal ab, so dass bei einer Interpolation grundsätzlich die genauesten Ergebnisse erzielt werden können, wenn die Bildpunktsignale der nächstgelegenen Bildpunkte verwendet werden. Um jedoch auch dann, wenn einer der beiden gleich weit entfernten Bildpunkte defekt ist, eine Interpolation durchführen zu können, wird anstelle des defekten gleich weit entfernten Bildpunkts ein in der entsprechenden Interpolationsrichtung weiter entfernt gelegener Bildpunkt, beispielsweise der zweitnächstgelegene Bildpunkt vorgegebener Farbe, für die Interpolation verwendet.

Bei einer Weiterbildung des Verfahrens umfassen die Signaldifferenzwerte einen weiteren diagonalen Signaldifferenzwert, der aus Bildpunktsignalen zweier der weiteren Bildpunkte bestimmt wird, die innerhalb des Umfelds um den PDAF-Bildpunkt in einer durch den PDAF-Bildpunkt verlaufenden und senkrecht zu der Diagonalenrichtung orientierten weiteren Diagonalenrichtung beidseits des PDAF-Bildpunkts angeordnet sind. Werden bei der Interpolation beide Diagonalenrichtungen berücksichtigt, approximiert das Interpolationssignal das bei einer vollflächigen Belichtung des PDAF-Bildpunkts erzeugte Bildsignal besonders genau.

Bei einer Weiterbildung des Verfahrens umfassen die Signaldifferenzwerte einen senkrechten Signaldifferenzwert, der aus Bildpunktsignalen zweier der weiteren Bildpunkte bestimmt wird, die innerhalb des Umfelds um den PDAF-Bildpunkt in einer durch den PDAF-Bildpunkt verlaufenden und senkrecht zu der ersten Richtung orientierten Normalenrichtung beidseits des PDAF-Bildpunkts angeordnet sind.

Bei einer Weiterbildung des Verfahrens sind die weiteren Bildpunkte, die zur Bestimmung der einzelnen Signaldifferenzwerte herangezogen werden, an Bildpunktpositionen eines Farbfilters des Bildsensors angeordnet, deren Farbe einer Farbe der Bildpunktposition des PDAF-Bildpunkts entspricht. Dadurch werden bei der Auswahl der für die Interpolation verwendeten weiteren Richtung lediglich diejenigen Bildstrukturen berücksichtigt, welche die gleiche Farbe wie die Bildpunktposition des PDAF-Bildpunkts aufweisen, so dass Farbfehler bei der Interpolation vermieden werden.

Bei einer Weiterbildung des Verfahrens werden die Signaldifferenzwerte aus Quadratwurzeln der zur Bestimmung der einzelnen Signaldifferenzwerte jeweils herangezogenen Bildpunktsignale bestimmt. Eine Bestimmung der Signaldifferenzwerte aus den Quadratwurzeln der Bildpunktsignale hat gegenüber einer Bestimmung der Signaldifferenzwerte aus den Bildpunktsignalen selbst den Vorteil, dass signalabhängige Rauschbeiträge der einzelnen Bildpunktsignale die Signaldifferenzwerte weniger beeinflussen. Da das Rauschen der einzelnen Bildpunktsignale üblicherweise mit der Belichtung zunimmt, würde das Rauschen der einzelnen Bildpunktsignale andernfalls dazu führen, dass die Signaldifferenzwerte bei gleicher Belichtungsdifferenz bei weniger belichteten Bildpunkten geringer sind als bei stärker belichteten Bildpunkten. Dies wiederum würde dazu führen, dass bei der Interpolation diejenigen Richtungen bevorzugt werden, in denen die Bildpunkte weniger belichtet werden als in den anderen weiteren Richtungen.

Bei einer Weiterbildung des Verfahrens weisen der PDAF-Bildpunkt und der mindestens eine weitere PDAF-Bildpunkt jeweils eine Blende auf, die den jeweiligen PDAF-Bildpunkt entlang einer senkrecht zu der ersten Richtung orientierten Blendenkante in einen freiliegenden und in einen abgedeckten Teil teilt. Damit verläuft die Strukturrichtung, falls sie um weniger als den vorgegebenen Winkel von der ersten Richtung abweicht und das Ausgabesignal des PDAF-Bildpunkts als das verstärkte Signal erzeugt wird, senkrecht zu der den PDAF-Bildpunkt in den freiliegenden und abgedeckten Teil unterteilenden Blendenkante.

Es kann daher davon ausgegangen werden, dass der freiliegende Teil des PDAF-Bildpunkts und der abgedeckte Teil des PDAF-Bildpunkts jeweils mit der gleichen Intensität belichtet werden und dass folglich eine Korrektur des mittels des teilweise abgedeckten PDAF-Bildpunkts erfassten Bildsignals mit dem vorgegebenen Verstärkungsfaktor das bei einer vollständigen Belichtung des PDAF-Bildpunkts erzeugte Signal reproduziert. Dies wäre beispielsweise bei einer parallelen Orientierung der Blendenkante und der ersten Richtung nicht der Fall, da dann beispielsweise die auf den freiliegenden Teil des PDAF-Bildpunkts eintreffende Strahlung unabhängig von dem Abstand ist, indem eine auf den abgedeckten Teil des PDAF-Bildpunkts abgebildete Strukturkante der Bildstruktur entlang der Blendenkante des PDAF-Bildpunkts verläuft. Bei dem Bildsensor können insbesondere alle PDAF-Bildpunkte innerhalb des zur Erzeugung des Ausgabesignals herangezogenen Umfelds entlang senkrecht zu der PDAF-Bildpunktreihe verlaufenden Blendenkanten in einen freiliegenden und in einen abgedeckten Teil geteilt sein.

Die senkrechte Orientierung der Blendenkanten einzelner, mehrerer oder aller PDAF-Bildpunkte der PDAF-Bildpunktreihe gegenüber der parallel zu der PDAF-Bildpunktreihe verlaufenden ersten Richtung stellt einen eigenständigen Aspekt der vorliegenden Erfindung dar, welcher insbesondere unabhängig ist von der Art und Weise, mit der das Ausgabesignal des PDAF-Bildpunkts erzeugt wird, wenn die Strukturrichtung um mehr als den vorgegebenen Winkel von der ersten Richtung abweicht. Die Erfindung ist daher insbesondere auch allgemein auf Verfahren oder Bildsensoren gerichtet, bei denen der Bildsensor PDAF-Bildpunkte umfasst, die in einzelnen, parallel zueinander angeordneten PDAF-Bildpunktreihen angeordnet sind und deren Blendenkanten senkrecht zu den einzelnen PDAF-Bildpunktreihen orientiert sind und bei denen das Ausgabesignal des PDAF-Bildpunkt als das verstärkte Signal erzeugt wird, wenn die Strukturrichtung der abgebildeten Bildstruktur um weniger als den vorgegebenen Winkel von der ersten Richtung abweicht.

Bei einer Weiterbildung des Verfahrens sind der PDAF-Bildpunkt und der weitere PDAF-Bildpunkt innerhalb des Umfelds an in der ersten Richtung einander nächstgelegenen Bildpunktpositionen gleicher Farbe angeordnet. Werden die einzelnen PDAF-Bildpunkte besonders nah zueinander angeordnet, so kann die Phasendifferenz zwischen den aus unterschiedlichen Richtungen auf den Bildsensor treffenden Anteilen der einfallenden elektromagnetischen Strahlung und damit auch die Fokuslage der scharfzustellenden Optik besonders genau bestimmt werden. Eine Anordnung der PDAF-Bildpunkte an Bildpunktpositionen gleicher Farbe hat darüber hinaus den Effekt, dass in der Umgebung der PDAF-Bildpunktreihe lediglich die Bildpunkte einer Farbe modifiziert werden und damit die Bildpunktsignale aller übrigen Farben korrekt erfasst werden können.

Bei einer Weiterbildung des Verfahrens umfasst der Bildsensor eine Farbfiltermatrix, bei der alle Bildpunkte, die in der entlang der ersten Richtung verlaufenden und die PDAF-Bildpunkte umfassenden PDAF-Bildpunktreihe angeordnet sind, die gleiche Filterfarbe aufweisen. Insbesondere weisen die PDAF-Bildpunkte und die vollflächig belichteten weiteren Bildpunkte in der PDAF-Bildpunkreihe Farbfilter mit der gleichen Filterfarbe auf. Die PDAF-Bildpunkte können dabei jeweils an Bildpunktpositionen der Farbfiltermatrix angeordnet sein, welchen eine Farbe zugeordnet ist, die sich von der Filterfarbe der Farbfilter der PDAF-Bildpunkte unterscheidet. Außerdem können die weiteren, vollflächig ausgebildeten Bildpunkte der PDAF-Bildpunktreihe jeweils an Bildpunktpositionen angeordnet sein, deren Farbe der Filterfarbe der in der PDAF-Bildpunktreihe angeordneten Bildpunkte entspricht.

Beispielswiese können bei einer Bayer-Farbfiltermatrix alle PDAF-Bildpunkte in der PDAF-Bildpunktreihe an blauen oder roten Bildpunktpositionen angeordnet sein und keinen blauen bzw. roten Farbfilter, sondern einen andersfarbigen Farbfilter umfassen, während alle weiteren Bildpunkte innerhalb der PDAF-Bildpunktreihe an grünen Bildpunktpositionen angeordnet sind und einen grünen Farbfilter umfassen. Es können aber auch alle PDAF-Bildpunkte in der PDAF-Bildpunktreihe an grünen Bildpunktpositionen angeordnet sein und keinen grünen, sondern einen andersfarbigen Farbfilter umfassen, während alle weiteren Bildpunkte innerhalb der PDAF-Bildpunktreihe an blauen oder roten Bildpunktpositionen angeordnet sind und einen blauen bzw. roten Farbfilter umfassen.

Es wird außerdem eine Sensoreinrichtung mit einem optoelektronischen Bildsensor und einer Auswerteeinrichtung zur Erzeugung eines Ausgabesignals eines PDAF-Bildpunkts des optoelektronischen Bildsensors angegeben, wobei die Auswerteeinrichtung dazu eingerichtet ist, das Ausgabesignal des PDAF-Bildpunkts unter Verwendung von Bildpunktsignalen von in einem Umfeld des PDAF-Bildpunkts angeordneten weiteren Bildpunkten des Bildsensors zu erzeugen. Der Bildsensor weist innerhalb des zur Erzeugung des Ausgabesignals herangezogenen Umfelds in einer entlang einer ersten Richtung verlaufenden PDAF-Bildpunktreihe den PDAF-Bildpunkt und mindestens einen weiteren PDAF-Bildpunkt auf. Die Auswerteeinrichtung ist dazu eingerichtet, Bildpunktsignale der innerhalb des Umfelds angeordneten Bildpunkte des Bildsensors zu erfassen und eine Strukturrichtung einer auf den Bildsensor abgebildeten Bildstruktur aus den Bildpunktsignalen zumindest eines Teils der innerhalb des Umfelds angeordneten Bildpunkte zu bestimmen. Außerdem ist die Auswerteeinrichtung dazu eingerichtet, das Ausgabesignal des PDAF-Bildpunkts in einem Fall als Interpolationssignal aus den Bildpunktsignalen von innerhalb des Umfelds angeordneten weiteren Bildpunkten und in einem anderen Fall als verstärktes Signal durch Korrektur des Bildpunktsignals des PDAF-Bildpunkts mit einem Verstärkungsfaktor zu erzeugen, wobei die Auswerteeinrichtung dazu eingerichtet ist, das Ausgabesignal des PDAF-Bildpunkts als das verstärkte Signal zu erzeugen, falls die Strukturrichtung um weniger als einen vorgegebenen Winkel von der ersten Richtung abweicht.

Die Auswerteeinrichtung der Sensoreinrichtung ist insbesondere dazu ausgebildet, das vorgenannte Verfahren auszuführen. Insofern beziehen sich alle Vorteile und Weiterbildungen, die im Zusammenhang mit dem vorgenannten Verfahren beschrieben werden, auch auf die Sensoreinrichtung bzw. die Auswerteeinrichtung.

Die Erfindung bezieht sich weiter auf eine Kamera mit der vorgenannten Sensoreinrichtung. Die Kamera kann insbesondere als eine spiegellose Kamera, etwa als eine spiegellose Systemkamera ausgebildet sein.

Die Erfindung wird nachfolgend anhand von Figuren erläutert. Dabei zeigen in jeweils schematischer Darstellung:

Fig. 1 eine Sensoreinrichtung mit einem optoelektronischen Bildsensor und einer Auswerteeinrichtung;

Fig. 2 einen Ausschnitt des optoelektronischen Bildsensors mit einer PDAF-Bildpunktreihe;

Fig. 3 einen PDAF-Bildpunkt mit einer zur Erzeugung eines Ausgangssignals des PDAF-Bildpunkts herangezogenen Umgebung des PDAF-Bildpunkts;

Fig. 4 die Umgebung mit einer entlang einer Strukturrichtung verlaufenden Strukturkante der Bildstruktur;

Fig. 5 die Umgebung mit zur Bestimmung eines ersten Kontrastwerts herangezogenen ersten Bildpunktpaaren;

Fig. 6 die Umgebung mit zur Bestimmung eines zweiten Kontrastwerts herangezogenen zweiten Bildpunktpaaren;

Fig. 7 die Umgebung mit zur Bestimmung eines Interpolationssignals herangezogenen Interpolationsrichtungen;

Fig. 8 eine weitere Umgebung eines PDAF-Bildpunkts eines weiteren Bildsensors mit in einer Diagonalenrichtung unterschiedlich weit von dem PDAF-Bildpunkt entfernten weiteren Bildpunkten, sowie mit in einer weiteren Diagonalenrichtung dem PDAF-Bildpunkt nächstgelegenen weiteren Bildpunkten;

Fig. 9 ein Verfahren zur Erzeugung eines Ausgabesignals des PDAF Bildpunkts; und

Fig. 10 ein weiteres Verfahren zur Erzeugung eines Ausgabesignals des PDAF Bildpunkts.

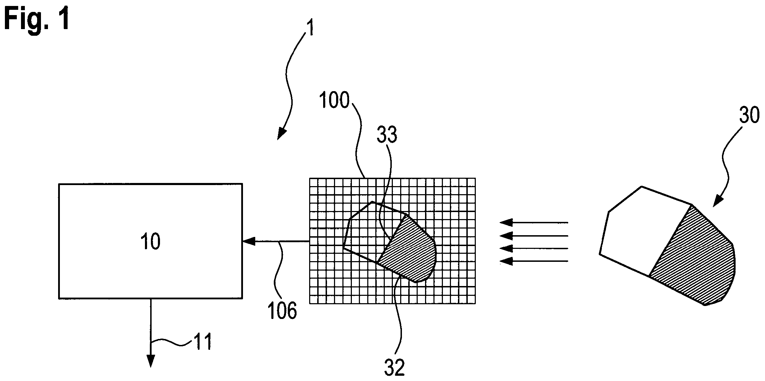

Fig. 1 zeigt eine Sensoreinrichtung 1 mit einem optoelektronischen Bildsensor 100 und einer Auswerteeinrichtung 10. Auf den optoelektronischen Bildsensor 100 wird ein Objekt 30 als eine Bildstruktur 32 abgebildet. Der optoelektronische Bildsensor 100 umfasst eine regelmäßige Anordnung einzelner Bildpunkte, welche jeweils Bildpunktsignale 106 erzeugen, die von der durch die Bildstruktur 32 vorgegebenen Intensität der auf die einzelnen Bildpunkte einfallenden elektromagnetischen Strahlung abhängen. Die Auswerteeinrichtung 10 ist mit dem optoelektronischen Bildsensor 100 verbunden, um die Bildpunktsignale 106 zu erfassen und zu Ausgabesignalen 11 zu verarbeiten. Die Auswerteeinrichtung 10 ist dazu ausgebildet, die Ausgabesignale 11 derart zu erstellen, dass die Ausgabesignale 11 möglichst genau die auf die einzelnen Bildpunkte des Bildsensors 100 tatsächlich einfallende Intensität repräsentieren. Insbesondere ist die Auswerteeinrichtung 11 dazu ausgebildet, korrigierte Ausgabesignale 11 für teilweise abgeblendete PDAF-Bildpunkte des optoelektronischen Bildsensors 100 zu erstellen. Die Sensoreinrichtung 1 ist in einer in Fig. 1 nicht dargestellten digitalen Kamera angeordnet.

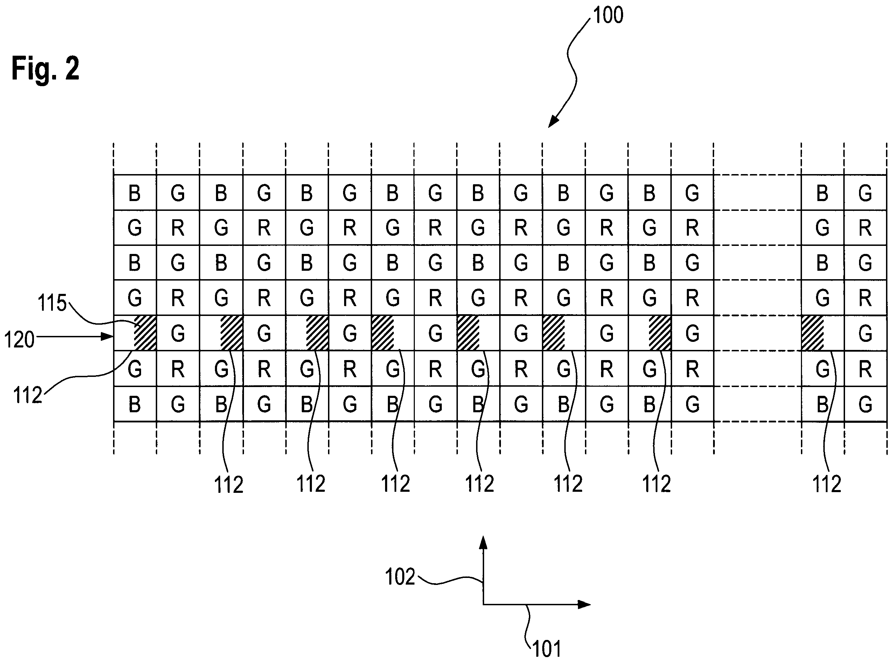

In Fig. 2 ist ein Ausschnitt des optoelektronischen Bildsensors 100 dargestellt, welcher eine PDAF-Bildpunktreihe 120 mit entlang der PDAF-Bildpunktreihe 120 angeordneten PDAF-Bildpunkten 112 umfasst. Die PDAF-Bildpunktreihe 120 wird durch eine entlang einer ersten Richtung 101 orientierte Bildpunktzeile des optoelektronischen Bildsensors 100 gebildet. In einer senkrecht zu der ersten Richtung 101 orientierten und eine Normalenrichtung bildenden zweiten Richtung 102 umfasst der Bildsensor 100 nicht dargestellte weitere PDAF-Bildpunktreihen 120, welche beispielsweise regelmäßig voneinander beabstandet sind. Die PDAF-Bildpunkte 112 werden jeweils halbseitig von einer Blende 115 abgedeckt, so dass die einfallende Strahlung lediglich auf einen neben der Blende 115 freiliegenden Teil der PDAF-Bildpunkte 112 trifft.

Wie aus Fig. 2 hervorgeht, weist der optoelektronische Bildsensor 100 eine als Bayer-Matrix ausgebildete Farbfiltermatrix auf, welche grüne Bildpunktpositionen G, blaue Bildpunktpositionen B und rote Bildpunktpositionen R umfasst. Die an den einzelnen Bildpunktpositionen G, B, R angeordneten Bildpunkte des Bildsensors 100 umfassen, soweit sie nicht in der PDAF-Bildpunktreihe 120 angeordnet sind, jeweils einen Farbfilter, dessen Farbe der Farbe der entsprechenden Bildpunktpositionen G, B, R entspricht.

Innerhalb der PDAF-Bildpunktreihe 120 sind an den blauen Bildpunktpositionen jeweils die PDAF-Bildpunkte 112 angeordnet. Die PDAF-Bildpunkte 112 weisen jedoch keinen blauen, sondern einen andersfarbigen Farbfilter auf. Zwischen den einzelnen PDAF-Bildpunkten 112 sind in der PDAF-Bildpunktzeile 120 jeweils vollflächig belichtete weitere Bildpunkte an allen grünen Bildpunktpositionen G der Farbfiltermatrix angeordnet, welche grüne Farbfilter aufweisen.

In der PDAF-Bildpunktreihe 120 sind zwei unterschiedliche Typen von PDAF-Bildpunkten 112 angeordnet, welche jeweils auf in der ersten Richtung entgegengesetzten Seiten abgedeckt sind, nämlich ein linksseitig abgedeckter Typ und ein rechtsseitig abgedeckter Typ von PDAF-Bildpunkten 112. Dabei umfasst die Bildpunktreihe 120 jeweils alternierend drei auf gleichfarbigen Bildpunktpositionen nebeneinander angeordnete linksseitig abgedeckte PDAF-Bildpunkte 112 und drei auf gleichfarbigen Bildpunktpositionen nebeneinander angeordnete rechtsseitig abgedeckte PDAF-Bildpunkte 112.

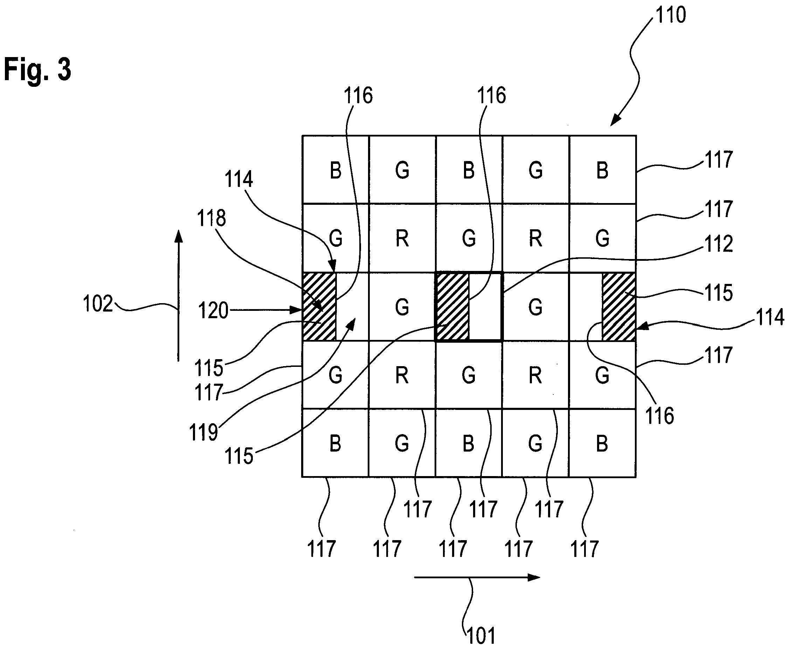

Fig. 3 zeigt ein zur Erzeugung des Ausgabesignals 11 eines der PDAF-Bildpunkte 112 herangezogenes Umfeld 110 des betreffenden PDAF-Bildpunkts 112. Der PDAF-Bildpunkt 112, dessen Ausgabesignal 11 anhand des Umfelds 110 bestimmt wird, ist mittig innerhalb des Umfelds 110 angeordnet, wobei das Umfeld 110 entlang der ersten Richtung 101 und entlang der zweiten Richtung 102 jeweils eine Breite von fünf Bildpunkten aufweist. Da in der PDAF-Bildpunktreihe 120 jeder zweite Bildpunkt ein PDAF-Bildpunkt ist, sind innerhalb des Umfelds 110 in der PDAF-Bildpunktreihe 120 beidseits des PDAF-Bildpunkts 112 zwei weitere PDAF-Bildpunkte 114 angeordnet.

Wie in Fig. 3 ebenfalls dargestellt ist, unterteilen die Blenden 115 der PDAF-Bildpunkte 112, 114 die einzelnen PDAF-Bildpunkte 112, 114 jeweils entlang einer parallel zu der zweiten Richtung 102 verlaufenden Blendenkante 116 in einen freiliegenden und damit belichteten Teil 119 und in einen abgedeckten und daher unbelichteten Teil 118. Alle übrigen Bildpunkte innerhalb des Umfelds 110 sind als vollflächig belichtete weitere Bildpunkte 117 ausgebildet.

Da die PDAF-Bildpunkte 112, 114 jeweils durch die Blende 115 abgeschattet werden, können ihre Bildpunktsignale 106 nicht direkt als Ausgabesignal 11 verwendet werden. Daher ist die Auswerteeinrichtung 10 dazu eingerichtet, die Ausgabesignale 11 der PDAF-Bildpunkte 112, 114 jeweils unter Verwendung der Bildpunktsignale 106 von Bildpunkten, die innerhalb eines Umfelds um den betreffenden PDAF-Bildpunkt 112, 114 gelegen sind, entweder als ein Interpolationssignal oder als ein verstärktes Signal zu erzeugen. Insbesondere wird das in Fig. 3 dargestellte Umfeld 110 zur Erzeugung des Ausgabesignals 11 des in Fig. 3 dargestellten und im Zentrum des Umfelds 110 gelegenen PDAF-Bildpunkts 112 verwendet. Zur Erzeugung der Ausgabesignale 11 der in Fig. 3 dargestellten weiteren PDAF-Bildpunkte 114 werden anlog jeweils um die weiteren Bildpunkte 114 zentrierte Umfelder herangezogen.

Ob das Ausgabesignal 11 des PDAF-Bildpunkts 112 als Interpolationssignal oder als verstärktes Signal erzeugt wird, hängt davon ab, wie die auf den Bildsensor 100 abgebildete Bildstruktur 32 im Bereich des Umfelds 110 um den PDAF-Bildpunkt 112 orientiert ist. Insbesondere hängt die Art und Weise der Erzeugung des Ausgabesignals 11 von einer Strukturrichtung der Bildstruktur 32 ab, entlang derer Grenzlinien zwischen hellen und dunklen Bereichen der Bildstruktur 32 verlaufen. Beispielsweise ist die in Fig. 1 dargestellte Bildstruktur 32 in einen hellen und einen dunklen Bereich strukturiert, wobei die Grenzlinie zwischen dem hellen und dem dunklen Bereich eine Strukturkante 33 bildet und die Strukturrichtung der Bildstruktur 32 festlegt.

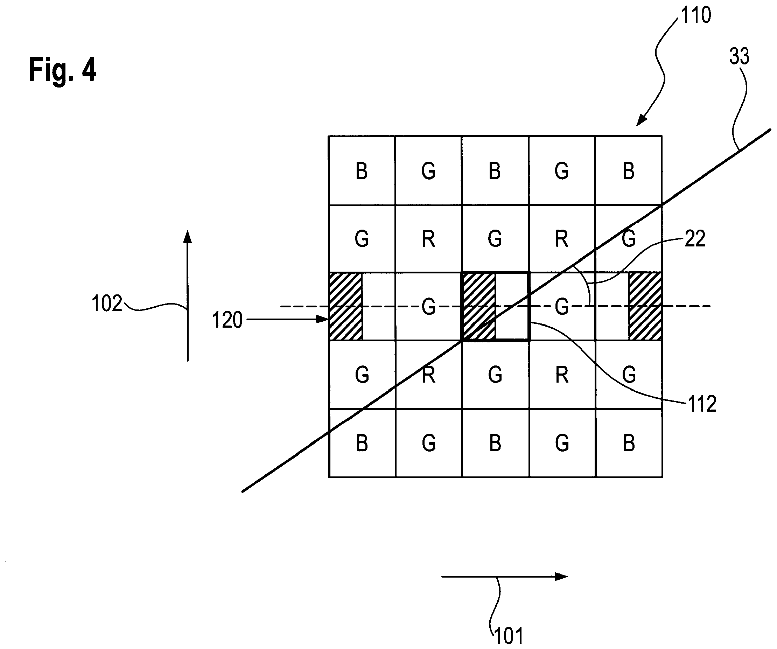

Wie in Fig. 4 dargestellt ist, ist die Strukturrichtung der Bildstruktur 32 innerhalb des Umfelds 110 durch einen Winkel 22 zwischen der entlang der Strukturrichtung verlaufenden Strukturkante 33 und der ersten Richtung 101 festgelegt. In allen Fällen, in denen der Winkel 22 höchstens einem vorgegebenen Winkel von beispielsweise 18° oder 22,5° entspricht, die Strukturrichtung also im Wesentlichen entlang der ersten Richtung 101 verläuft, wird das Ausgabesignal 11 als das verstärkte Signal aus dem Bildpunktsignal 106 des PDAF-Bildpunkts 112 bestimmt. In allen anderen Fällen wird das Ausgabesignal 11 als Interpolationssignal aus den Bildsignalen 106 der innerhalb des Umfelds 110 um den PDAF-Bildpunkt 112 herum angeordneten weiteren Bildpunkte 117 erzeugt.

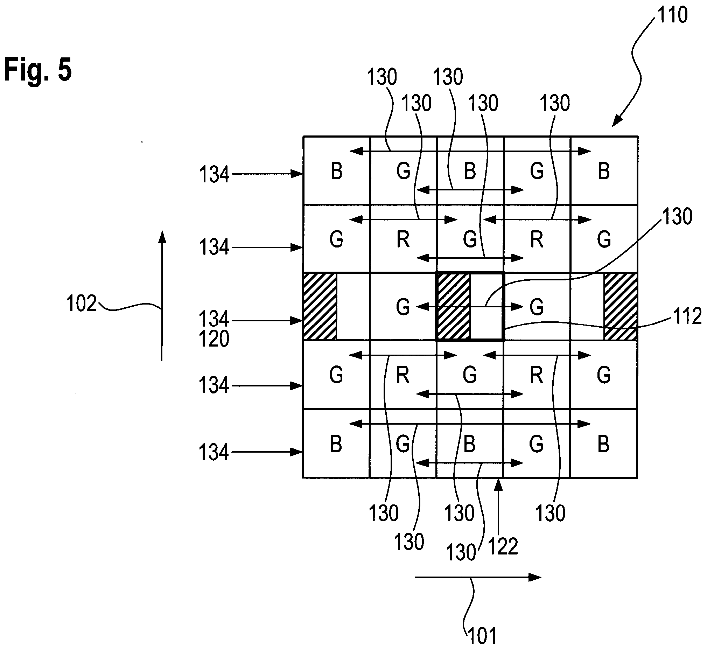

Zur Bestimmung der Strukturrichtung bestimmt die Auswerteeinrichtung 10 einen ersten Kontrastwert, welcher einen Kontrast der Bildstruktur 32 entlang der ersten Richtung 101 angibt, und einen zweiten Kontrastwert, welcher einen Kontrast der Bildstruktur 32 entlang der zweiten Richtung 102 angibt. Wie in Fig. 5 dargestellt ist, wird der erste Kontrastwert anhand einer Mehrzahl erster Bildpunktpaare 130 bestimmt, wobei die einzelnen ersten Bildpunktpaare 130 jeweils zwei Bildpunkte gleicher Farbe umfassen, die jeweils in gemeinsamen, entlang der ersten Richtung 101 verlaufenden ersten Bildpunktreihen 134 angeordnet sind. Die ersten Bildpunktreihen 134 werden insbesondere durch Bildpunktzeilen des Bildsensors 100 gebildet.

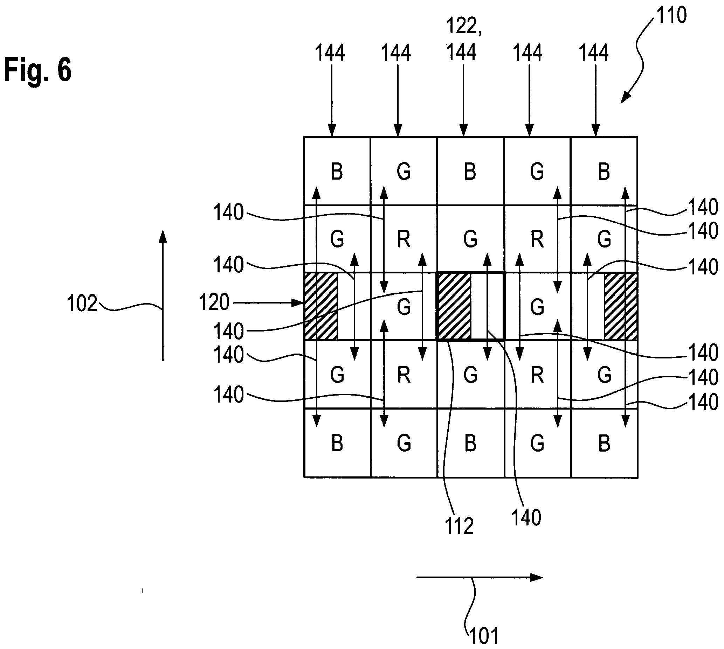

Analog wird der zweite Kontrastwert, wie in Fig. 6 dargestellt, anhand einer Mehrzahl zweiter Bildpunktpaare 140 bestimmt. Die einzelnen zweiten Bildpunktpaare 140 umfassen jeweils zwei Bildpunkte gleicher Farbe, die jeweils in gemeinsamen, entlang der zweiten Richtung 102 verlaufenden zweiten Bildpunktreihen 144 angeordnet sind. Die zweiten Bildpunktreihen 144 werden insbesondere durch Bildpunktspalten des Bildsensors 100 gebildet. Die Anordnung der zweiten Bildpunktpaare 140 entspricht dabei der aus der ersten Richtung 101 in die zweite Richtung 102, also um 90°, gedrehten Anordnung der ersten Bildpunktpaare 130.

Der erste Kontrastwert, welcher auch als horizontaler Kontrastwert bezeichnet werden kann, wird als Summe der Differenzbeträge der Bildpunktsignale 106 der Bildpunkte der einzelnen ersten Bildpunktpaare 130 gebildet zu

$$C_h = \sum_i |c_{h,i}|$$

mit den Differenzbeträgen $|c_{h,i}| = |y_{2,i} - y_{1,i}|$ der einzelnen Bildpunktsignale $y_{1,i}$, $y_{2,i}$ des i-ten ersten Bildpunktpaares 130.

Analog wird der zweite Kontrastwert, welcher auch als vertikaler Kontrastwert bezeichnet werden kann, als Summe der Differenzbeträge der Bildpunktsignale 106 der Bildpunkte der zweiten Bildpunktpaare 140 gebildet zu

$$C_v = \sum_i |c_{v,i}|$$

mit den Differenzbeträgen $|c_{v,i}| = |y_{2,i} - y_{1,i}|$ der einzelnen Bildpunktsignale $y_{1,i}$, $y_{2,i}$ des $i$-ten zweiten Bildpunktpaares 140. Da die zur Erzeugung der Bildpunktsignale $y_{1,i}$, $y_{2,i}$ herangezogenen Bildpunkte eines ersten bzw. zweiten Bildpunktpaares 130, 140 jeweils die gleiche Farbe haben, bilden die Differenzbeträge $|c_{h,i}|$, $|c_{v,i}|$ jeweils farbspezifische Einzelkontraste, die jeweils zu einem horizontalen bzw. vertikalen Gesamtkontrast aufsummiert werden.

Die in Fig. 5 dargestellte Mehrzahl horizontal orientierter erster Bildpunktpaare 130 umfasst sowohl erste Bildpunktpaare 130, deren Bildpunkte symmetrisch zu einer entlang der zweiten Richtung 102 ausgerichteten und den PDAF-Bildpunkt 112 umfassenden zentralen Bildpunktreihe 122 angeordnet sind, als auch erste Bildpunktpaare 130, deren Bildpunkte asymmetrisch zu der zentralen Bildpunktreihe 122 angeordnet sind. Beispielsweise sind Bildpunkte der blauen und grünen ersten Bildpunktpaare 130 in den in der zweiten Richtung 102 an den äußeren Rändern des Umfelds 110 angeordneten äußersten ersten Bildpunktreihen 134 symmetrisch zu der zentralen Bildpunktreihe 122 angeordnet. Ebenso sind die Bildpunkte des in der PDAF-Bildpunktreihe 120 angeordneten grünen ersten Bildpunktpaars 130, sowie die Bildpunkte der roten ersten Bildpunktpaare 130 in den zwischen der PDAF-Bildpunktreihe 120 und den beiden in der zweiten Richtung 102 äußersten ersten Bildpunktreihen 134 symmetrisch um die zentrale Bildpunktreihe 122 angeordnet. Dagegen sind die Bildpunkte der grünen ersten Bildpunktpaare 130, die in den zwischen der PDAF-Bildpunktzeile 120 und den in der zweiten Richtung 102 äußersten ersten Bildpunktreihen 134 liegenden ersten Bildpunktreihen 134 angeordnet sind, asymmetrisch zu der zentralen Bildpunktreihe 122 angeordnet.

Analog umfasst auch die in Fig. 6 dargestellte Mehrzahl vertikal orientierter zweiter Bildpunktpaare 140 sowohl zweite Bildpunktpaare 140, deren Bildpunkte symmetrisch zu einer durch die PDAF-Bildpunktreihe 120 gebildeten weiteren zentralen Bildpunktreihe angeordnet sind, als auch zweite Bildpunktpaare 140, deren Bildpunkte asymmetrisch zu der weiteren zentralen Bildpunktreihe angeordnet sind. Beispielsweise sind die Bildpunkte der zweiten Bildpunktpaare 140, die in den in der ersten Richtung 101 äußersten zweiten Bildpunktreihen 144 des Umfelds 110 angeordnet sind, symmetrisch zu der durch die PDAF-Bildpunktreihe 120 gebildeten weiteren zentralen Bildpunktreihe angeordnet, während die Bildpunkte derjenigen grünen zweiten Bildpunktpaare 140, die in den zwischen der zentralen Bildpunktreihe 122 und den beiden in der ersten Richtung 101 äußersten zweiten Bildpunktreihen 144 gelegenen zweiten Bildpunktreihen 144 angeordnet sind, asymmetrisch zu der weiteren zentralen Bildpunktreihe angeordnet.

Das aus dem zweiten Kontrastwert und dem ersten Kontrastwert gebildete Kontrastverhältnis

$$\frac{C_v}{C_h}$$

ist ein Maß für die Abweichung der Strukturrichtung von der ersten Richtung 101 und entspricht dem Kotangens des Winkels 22. Überschreitet das Kontrastverhältnis einen vorgegebenen Grenzwert, beispielsweise einen Grenzwert von 3 oder 2,4, entsprechend einem Winkel 22 von 18° bzw. 22,5°, so wird das Ausgabesignal 11 des PDAF-Bildpunkts 112 als das verstärkte Signal erzeugt, andernfalls wird das Ausgabesignal 11 als Interpolationssignal erzeugt. Alternativ kann der vorgegebene Grenzwert auch 4 betragen, entsprechend einem Winkel 22 von etwa 14°. In diesem Fall wird eine besonders schnelle Datenverarbeitung ermöglicht, da sogenannte "Bit-Shift" Operationen bei einem durch den Faktor zwei teilbaren Grenzwert besonders schnell ausgeführt werden können.

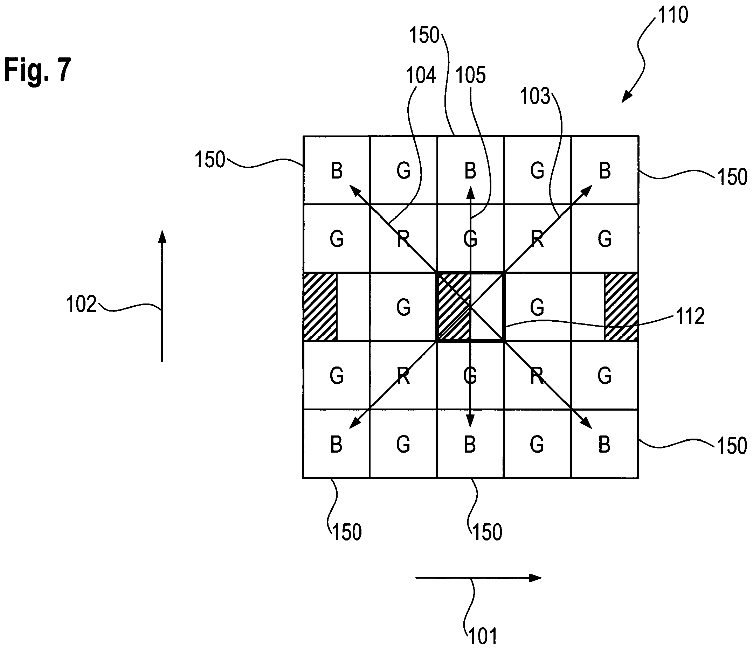

Wie in Fig. 7 dargestellt ist, erfolgt die Interpolation entlang einer von der ersten Richtung 101 verschiedenen Interpolationsrichtung, insbesondere entweder entlang einer Diagonalenrichtung 103, entlang einer weiteren Diagonalenrichtung 104 oder entlang einer der zweiten Richtung 102 entsprechenden Normalenrichtung 105. Das Interpolationssignal wird aus den Bildpunktsignalen der entlang der verwendeten Interpolationsrichtung dem PDAF-Bildpunkt 112 nächstgelegenen weiteren Bildpunkte 150 erzeugt, welche an Bildpunktpositionen angeordnet sind, die die gleiche Farbe aufweisen wie die Bildpunktposition des PDAF-Bildpunkts 112, also bei dem in Fig. 7 dargestellten Bildsensor 100 an blauen Bildpunktpositionen.

Bei einer Interpolation entlang der ersten Diagonalenrichtung 103 wird das Ausgabesignal 11 des PDAF-Bildpunkts 112 aus den Bildpunktsignalen der in der oberen rechten und der unteren linken Ecke des Umfelds 110 angeordneten blauen Bildpunkte erstellt, bei einer Interpolation entlang der weiteren Diagonalenrichtung 104 aus den Bildpunktsignalen der in der oberen linken und der unteren rechten Ecke des Umfelds 110 angeordneten Bildpunkte und bei einer Interpolation entlang der Normalenrichtung 105 aus den Bildpunktsignalen der blauen Bildpunkte, welche am oberen und am unteren Rand des Umfelds 110 in der gleichen Spalte wie der PDAF-Bildpunkt 112 angeordnet sind.

Als die Interpolationsrichtung wird diejenige der Richtungen 102, 103, 105 ausgewählt, entlang derer Signaldifferenzwerte zwischen den Bildpunktsignalen der für die Interpolation verwendeten nächstgelegenen Bildpunkte 150 minimal ist. Die einzelnen Signaldifferenzwerte $d_j$ der $j$-ten weiteren Richtung 102, 103, 105 werden dabei als Differenzen der Quadratwurzeln der einzelnen Bildpunktsignale $y1_j$, $y2_j$ bestimmt zu

$$d_j = \left| \sqrt{y1_j} - \sqrt{y2_j} \right|$$

und es wird entlang derjenigen Interpolationsrichtung 103, 104, 105 interpoliert, entlang derer der Signaldifferenzwert $d_j$ minimal ist.

Das Interpolationssignal $y_{PDAF,I}$ entspricht einem Mittelwert der Bildpunktsignale der beiden entlang der ausgewählten Interpolationsrichtung beidseits des PDAF-Bildpunkts 112 nächstgelegenen Bildpunkte 150 blauer Farbe, beispielsweise kann das Interpolationssignal $y_{PDAF,I}$ dem arithmetischen Mittelwert der genannten Bildpunktsignale entsprechen und zu

$$y_{PDAF,I} = \frac{(y1_j + y2_j)}{2}$$

berechnet werden.

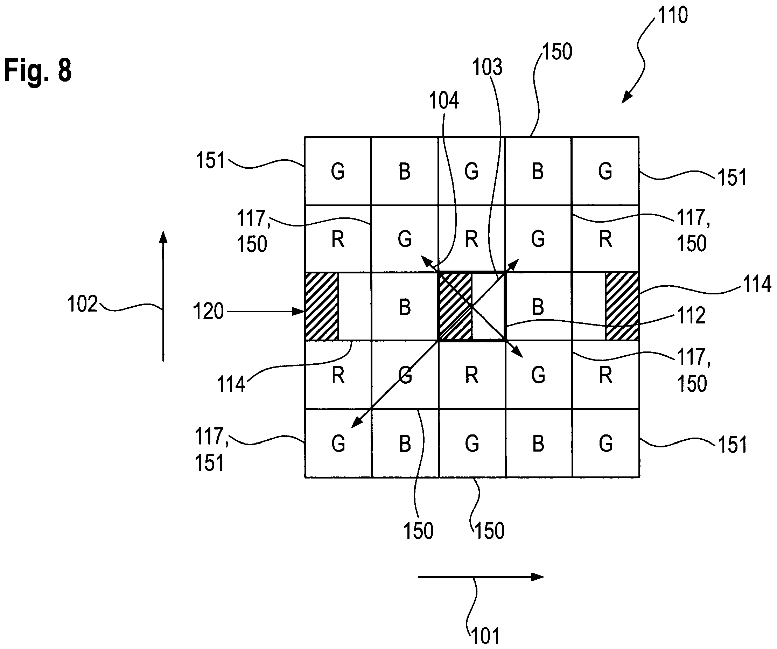

In Fig. 8 ist der Bildsensor 100 mit einer alternativen Anordnung der PDAF-Bildpunkte 112, 114 dargestellt. Dabei befinden sich die PDAF-Bildpunkte 112, 114 innerhalb der PDAF-Bildpunktreihe 120 nicht an Bildpunktpositionen blauer Farbe, sondern an Bildpunktpositionen grüner Farbe. Da bei einer Bayer-Farbmatrix entlang der durch die grünen Bildpunktpositionen G verlaufenden Diagonalenrichtungen 103, 104 ausschließlich grüne Bildpunktpositionen G angeordnet sind, umfasst das um den zu korrigierenden PDAF-Bildpunkt 112 angeordnete Umfeld 110 entlang der Diagonalenrichtungen 103, 104 beidseits des PDAF-Bildpunkts 112 jeweils zwei Bildpunkte mit einem grünen Farbfilter.

Insofern kann bei der in Fig. 8 dargestellten alternativen Anordnung der PDAF-Bildpunkte 112, 114 das Interpolationssignal bei einer Interpolation entlang der Diagonalenrichtungen 103, 104 nicht nur aus den dem PDAF-Bildpunkt 112 nächstgelegenen Bildpunkten 150 gleicher Farbe, sondern auch aus den dem PDAF-Bildpunkt 112 zweitnächstgelegenen Bildpunkten 151 gleicher Farbe, also den grünen Bildpunkten in den Ecken des Umfelds 110, erzeugt werden. Dabei können die Signaldifferenzwerte und das Interpolationssignal in den einzelnen Diagonalenrichtungen 103, 104 aus den nächstgelegenen und gleich weit entfernten Bildpunkten 150 gleicher Farbe bestimmt werden, falls in der betreffenden Diagonalenrichtung 103, 104 beide nächstgelegenen und gleich weit entfernten Bildpunkte 150 gleicher Farbe funktionsfähig sind, wie es in Fig. 8 für die weitere Diagonalenrichtung 104 dargestellt ist.

Ist jedoch einer der nächstgelegenen Bildpunkte 150 gleicher Farbe defekt, so kann anstelle des Bildpunktsignals des defekten nächstgelegenen Bildpunkts 150 das Bildpunktsignal des in der entsprechenden Diagonalenrichtung 103, 104 zweitnächstgelegenen Bildpunkts 151 gleicher Farbe zur Bestimmung der Signaldifferenzwerte und des Interpolationssignals herangezogen werden, wie es in Fig. 8 für die Diagonalenrichtung 103 dargestellt ist. In diesem Fall können der Signaldifferenzwert und das Interpolationssignal insbesondere aus Bildpunkten gleicher Farbe erzeugt werden, welche entlang der entsprechenden Diagonalenrichtung 103, 104 unterschiedlich weit von dem PDAF-Bildpunkt 112 entfernt sind.

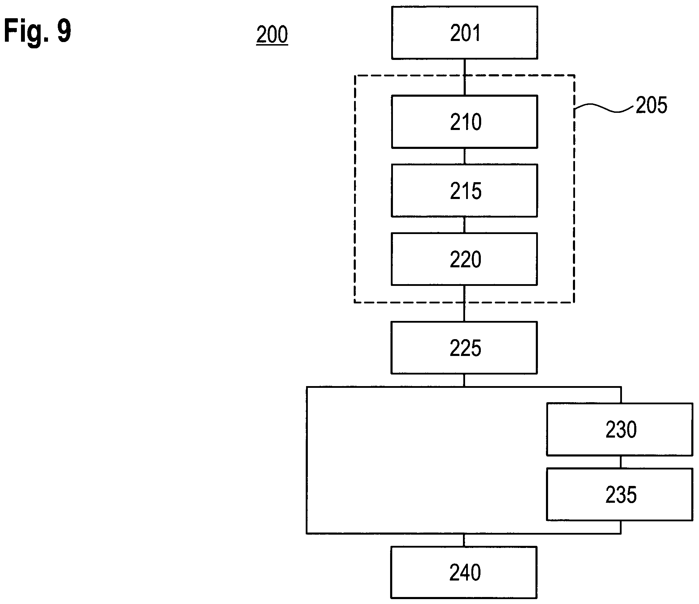

In Fig. 9 ist ein Verfahren 200 zur Erzeugung des Ausgabesignals 11 des PDAF-Bildpunkts 112 dargestellt. Das Verfahren 200 umfasst als ersten Schritt ein Erfassen 201 der Bildpunktsignale 106 der Bildpunkte des Bildsensors 100 durch die Auswerteeinheit 10. Danach umfasst das Verfahren 200 eine Interpolation 205 des Bildpunktsignals des PDAF-Bildpunkts 112 aus den Bildpunktsignalen 106 der innerhalb des Umfelds 110 angeordneten weiteren Bildpunkte 117. Hierzu werden erst die Signaldifferenzwerte $d_j$ bestimmt 210 und anschließend entlang derjenigen Interpolationsrichtung 103, 104, 105, entlang derer der Signaldifferenzwert minimal ist, der Mittelwert der Bildpunktsignale der nächstgelegenen Bildpunkte gleicher Farbe bestimmt 215. Schließlich wird zunächst das so erzeugte Interpolationssignal als Ausgabesignal festgelegt 220.

Anschließend umfasst das Verfahren 200 ein Bestimmen 225 der durch die Strukturkante 33 gegebenen Strukturrichtung der Bildstruktur 32. Weicht die Strukturrichtung höchstens um den vorgegebenen Winkel von der ersten Richtung 101 ab, so umfasst das Verfahren 200 eine Korrektur 230 des Bildpunktsignals 106 des PDAF-Bildpunkts 112 mit einem vorgegebenen Verstärkungsfaktor g, um ein verstärktes Signal

$$y_{PDAF,G} = (y_{PDAF} - y_0) \cdot g + y_0$$

zu bestimmen, wobei $y_{PDAF}$ das erfasste Bildpunktsignal des PDAF-Bildpunkts 112 und $y_0$ den Dunkelsignalanteil des PDAF-Bildpunkts 112 bezeichnet. Anschließend erfolgt ein Festlegen 235 des Ausgabesignals 11 des PDAF-Bildpunkts 112 als das mit dem Verstärkungsfaktor korrigierte verstärkte Signal, beispielsweise indem das vorher erzeugte Interpolationssignal in einer Speichereinheit der Auswerteeinrichtung 11 überschrieben wird. Abschließend umfasst das Verfahren 200 ein Erzeugen 240 und Ausgeben des festgelegten Ausgabesignals 11 des PDAF-Bildpunkts 112 durch die Auswerteeinrichtung 10.

Bei dem in Fig. 9 dargestellten Verfahren 200 erfolgt stets das Bestimmen 205 des Interpolationssignals und das Interpolationssignal wird lediglich in den Fällen, in denen die Strukturrichtung um höchstens den vorgegebenen Winkel von der ersten Richtung 101 abweicht, durch das verstärkte Signal ersetzt. Nachdem die Strukturrichtung bei einem vorgegebenen Winkel von weniger als 45°, insbesondere von 18° oder 22,5°, im Durchschnitt häufiger um mehr als den vorgegebenen Winkel von der ersten Richtung 101 abweicht als um weniger als den vorgegebenen Winkel, kann das Ausgabesignal 11 des PDAF-Bildpunkts 112 durch die in dem Verfahren 200 implementierte Reihenfolge des Bestimmens 205 des Interpolationssignals und der Bestimmung 230 des verstärkten Signals besonders schnell erzeugt werden.

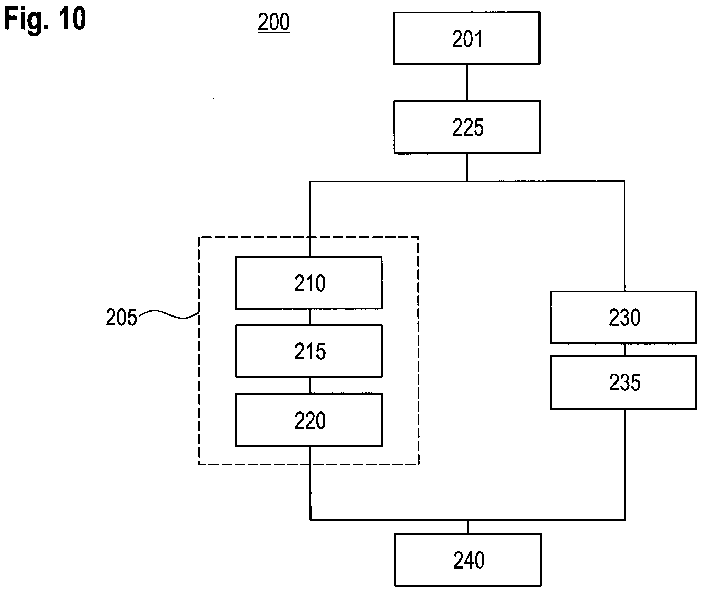

Fig. 10 zeigt eine alternative Ausführungsform des Verfahrens 200, bei der nach dem Erfassen 201 der Bildpunktsignale zunächst die Strukturrichtung bestimmt wird 225. Falls die Strukturrichtung um höchstens den vorgegebenen Winkel von der ersten Richtung 101 abweicht, erfolgt die Korrektur 230 mit dem Verstärkungsfaktor und das Festlegen 235 des verstärkten Signals als das Ausgabesignal. Falls die Strukturrichtung um mehr als den vorgegebenen Winkel von der ersten Richtung 101 abweicht, erfolgt bei dem in Fig. 10 dargestellten Verfahren die Interpolation 205 des Bildpunktsignals des PDAF-Bildpunkts 112 aus den Bildpunktsignalen 106 der innerhalb des Umfelds 110 angeordneten weiteren Bildpunkte 117, wie es bereits im Zusammenhang mit Fig. 9 beschrieben wurde. Abschließend wird das Ausgabesignal entweder als das verstärkte Signal oder als das Interpolationssignal erzeugt 240.

### Bezugszeichenliste

| | |
|---|---|
| 1 | Sensoreinrichtung |
| 10 | Auswerteeinrichtung |
| 11 | Ausgabesignal |
| 22 | Winkel |
| 30 | Objekt |
| 32 | Bildstruktur |
| 33 | Strukturkante |
| 100 | Bildsensor |
| 101 | erste Richtung |
| 102 | zweite Richtung |
| 103 | Diagonalenrichtung |
| 104 | weitere Diagonalenrichtung |
| 105 | Normalenrichtung |
| 106 | Bildpunktsignale |
| 110 | Umfeld |
| 112 | PDAF-Bildpunkt |
| 114 | weitere PDAF-Bildpunkte |
| 115 | Blende |
| 116 | Blendenkante |
| 117 | weitere Bildpunkte |
| 118 | abgedeckter Teil |
| 119 | freiliegender Teil |
| 120 | PDAF-Bildpunktreihe |
| 122 | zentrale Bildpunktreihe |
| 130 | erste Bildpunktpaare |
| 134 | erste Bildpunktreihen |
| 140 | zweite Bildpunktpaare |
| 144 | zweite Bildpunktreihen |
| 150 | nächstgelegene Bildpunkte |
| 151 | zweitnächstgelegene Bildpunkte |
| 200 | Verfahren zur Erzeugung eines Ausgabesignals |
| 201 | Erfassen von Bildpunktsignalen |
| 205 | Interpolation |
| 210 | Bestimmen von Signaldifferenzwerten |
| 215 | Bestimmen eines Mittelwerts |
| 220 | Festlegen des Interpolationssignals als Ausgabesignal |
| 225 | Bestimmen einer Strukturrichtung |
| 230 | Korrektur mit einem Verstärkungsfaktor |
| 235 | Festlegen des verstärkten Signals als Ausgabesignal |
| 240 | Erzeugen eines Ausgabesignals |

### Patentansprüche

**1.** Verfahren (200) zur Erzeugung eines Ausgabesignals (11) eines PDAF-Bildpunkts (112) eines optoelektronischen Bildsensors (100) unter Verwendung von Bildpunktsignalen (106) von in einem Umfeld (110) des PDAF-Bildpunkts (112) angeordneten weiteren Bildpunkten (117), wobei der Bildsensor (100) innerhalb des zur Erzeugung des Ausgabesignals (11) herangezogenen Umfelds (110) in einer entlang einer ersten Richtung (101) verlaufenden Bildpunktreihe den PDAF-Bildpunkt (112) und mindestens einen weiteren PDAF-Bildpunkt (114) aufweist,

wobei das Verfahren (200) umfasst:

- Erfassen (201) von Bildpunktsignalen (106) der innerhalb des Umfelds (110) angeordneten Bildpunkte (112, 114, 117) des Bildsensors (100),
- Bestimmen (225) einer Strukturrichtung einer auf den Bildsensor (100) abgebildeten Bildstruktur (32) aus den Bildpunktsignalen (106) zumindest eines Teils der innerhalb des Umfelds (110) angeordneten Bildpunkte (117), und

- Erzeugen (240) des Ausgabesignals (11) des PDAF-Bildpunkts (112),

wobei die Strukturrichtung als diejenige Richtung bestimmt wird, in der die abgebildete Bildstruktur (32) den geringsten Kontrast aufweist, wobei das Ausgabesignal (11) des PDAF-Bildpunkts (112) in einem Fall als Interpolationssignal aus den Bildpunktsignalen (106) von innerhalb des Umfelds (110) angeordneten weiteren Bildpunkte (117) und in einem anderen Fall als verstärktes Signal durch Korrektur (230) des Bildpunktsignals (106) des PDAF-Bildpunkts (112) mit einem Verstärkungsfaktor erzeugt wird, **gekennzeichnet dadurch, dass** das Ausgabesignal (11) des PDAF-Bildpunkts (112) als das verstärkte Signal erzeugt wird, falls die Strukturrichtung um weniger als einen vorgegebenen Winkel von der ersten Richtung (101) abweicht.

2. Verfahren (200) nach Anspruch 1,

wobei das Bildpunktsignal (106) des PDAF-Bildpunkts (112) zur Erzeugung des verstärkten Signals dadurch korrigiert wird, dass lediglich ein ein vorgegebenes Dunkelsignal des PDAF-Bildpunkts (112) übersteigender Signalanteil des Bildpunktsignals (106) des PDAF-Bildpunkts (112) mit dem Verstärkungsfaktor skaliert wird, und/oder wobei der vorgegebene Winkel mindestens 0°, mindestens 10° oder mindestens 13° und/oder höchstens 45°, höchstens 35° oder höchstens 23°, beispielsweise 14°, 18° oder 22,5° beträgt.

3. Verfahren (200) nach einem der vorhergehenden Ansprüche, wobei die Strukturrichtung aus einem ersten Kontrastwert und einem zweiten Kontrastwert der abgebildeten Bildstruktur (32) bestimmt wird, wobei der erste Kontrastwert einen Kontrast der Bildstruktur (32) entlang der ersten Richtung (101) und der zweite Kontrastwert einen Kontrast der Bildstruktur (32) entlang einer von der ersten Richtung (101) verschiedenen, beispielsweise entlang einer zu der ersten Richtung (101) orthogonalen, zweiten Richtung (102) spezifiziert.

4. Verfahren (200) nach Anspruch 3,

wobei der erste Kontrastwert unter Berücksichtigung einer Mehrzahl von ersten Bildpunktpaaren (130) erzeugt wird, die jeweils zwei der weiteren Bildpunkte (117) umfassen, die innerhalb des Umfelds (110) in entlang der ersten Richtung (101) verlaufenden ersten Bildpunktreihen (134) des Bildsensors (100) angeordnet sind, und/oder

wobei der zweite Kontrastwert unter Berücksichtigung einer Mehrzahl von zweiten Bildpunktpaaren (140) erzeugt wird, die jeweils zwei der weiteren Bildpunkte (117) umfassen, die innerhalb des Umfelds (110) in entlang der zweiten Richtung (102) verlaufenden zweiten Bildpunktreihen (144) des Bildsensors (100) angeordnet sind.

5. Verfahren (200) nach Anspruch 4, wobei jedes erste Bildpunktpaar (130) aus zwei weiteren Bildpunkten (117) besteht, die jeweils die gleiche Farbe aufweisen, und/oder jedes zweite Bildpunktpaar (140) aus zwei weiteren Bildpunkten (117) besteht, die jeweils die gleiche Farbe aufweisen.

6. Verfahren (200) nach einem der Ansprüche 4 und 5,

wobei der erste Kontrastwert eine Summe von Differenzbeträgen der Bildpunktsignale (106) der weiteren Bildpunkte (117) der einzelnen ersten Bildpunktpaare (130) umfasst und/oder wobei der zweite Kontrastwert eine Summe von Differenzbeträgen der Bildpunktsignale (106) der weiteren Bildpunkte (117) der einzelnen zweiten Bildpunktpaare (140) umfasst und/oder wobei eine Anordnung der zweiten Bildpunktpaare (140) einer aus der ersten Richtung (101) um den PDAF-Bildpunkt (112) in die zweite Richtung (102) gedrehten Anordnung der ersten Bildpunktpaare (130) entspricht.

7. Verfahren (200) nach einem der vorhergehenden Ansprüche, wobei die Strukturrichtung aus den Bildpunktsignalen (106) von Bildpunkten (117) unterschiedlicher Farbe bestimmt wird und/oder wobei die Strukturrichtung unter Ausschluss der Bildpunktsignale (106) des PDAF-Bildpunkts (112) und des weiteren PDAF-Bildpunkts (114) bestimmt wird.

8. Verfahren (200) nach einem der vorhergehenden Ansprüche, wobei das Ausgabesignal (11) des PDAF-Bildpunkts (112) als das Interpolationssignal erzeugt wird, falls die Strukturrichtung senkrecht zu der ersten Richtung (101) orientiert ist, vorzugsweise in allen Fällen, in denen die Strukturrichtung von der ersten Richtung (101) um mehr als den vorgegebenen Winkel abweicht.

9. Verfahren (200) nach einem der vorhergehenden Ansprüche, wobei das Verfahren (200) ein Bestimmen (210) mindestens zweier Signaldifferenzwerte umfasst,

wobei die einzelnen Signaldifferenzwerte aus Bildpunktsignalen (106) jeweils zweier der weiteren Bildpunkte (117) bestimmt werden, die innerhalb des Umfelds (110) um den PDAF-Bildpunkt (112) in durch den PDAF-Bildpunkt (112) verlaufenden und für die einzelnen Signaldifferenzwerte jeweils unterschiedlichen weiteren Richtungen (102, 103, 104, 105) beidseits des PDAF-Bildpunkts (112) angeordnet sind, und wobei das Interpolationssignal aus den Bildpunktsignalen (106) derjenigen weiterer Bildpunkte (117), die den kleinsten Signaldifferenzwert aufweisen, erzeugt wird,
wobei beispielsweise die weiteren Richtungen (102, 103, 104, 105) jeweils von der ersten Richtung (101) abweichen.

10. Verfahren (200) nach Anspruch 9,
wobei das Interpolationssignal als ein Mittelwert der Bildpunktsignale (106) derjenigen weiteren Bildpunkte (117), die den kleinsten Signaldifferenzwert aufweisen, erzeugt wird, beispielsweise als ein arithmetischer oder gewichteter Mittelwert.

11. Verfahren (200) nach einem der Ansprüche 9 bis 10,
wobei die Signaldifferenzwerte einen diagonalen Signaldifferenzwert umfassen, der aus Bildpunktsignalen (106) zweier weiterer Bildpunkte (117) bestimmt wird, die innerhalb des Umfelds (110) um den PDAF-Bildpunkt (112) in einer durch den PDAF-Bildpunkt (112) verlaufenden Diagonalenrichtung (103) beidseits des PDAF-Bildpunkts (112) angeordnet sind.

12. Verfahren (200) nach Anspruch 11,

wobei die diagonale Signaldifferenz aus dem Bildpunktsignal (106) zweier von dem PDAF-Bildpunkt (112) in der Diagonalenrichtung (103) gleich weit entfernter weiterer Bildpunkte (117) bestimmt wird, wenn beide gleich weit entfernten weiteren Bildpunkte (117) funktionsfähig sind,
wobei die diagonale Signaldifferenz aus Bildpunktsignalen (106) zweier in der Diagonalenrichtung (103) unterschiedlich weit von dem PDAF-Bildpunkt (112) entfernter weiterer Bildpunkte (117) bestimmt wird, wenn einer der in der Diagonalenrichtung (103) gleich weit entfernten weiteren Bildpunkte (117) defekt ist.

13. Verfahren (200) nach einem der Ansprüche 11 und 12,
wobei die Signaldifferenzwerte einen weiteren diagonalen Signaldifferenzwert umfassen, der aus Bildpunktsignalen (106) zweier der weiteren Bildpunkte (117) bestimmt wird, die innerhalb des Umfelds (110) um den PDAF-Bildpunkt (112) in einer durch den PDAF-Bildpunkt (112) verlaufenden und senkrecht zu der Diagonalenrichtung (103) orientierten weiteren Diagonalenrichtung (104) beidseits des PDAF-Bildpunkts (112) angeordnet sind.

14. Verfahren (200) nach einem der Ansprüche 9 bis 13,
wobei die Signaldifferenzwerte einen senkrechten Signaldifferenzwert umfassen, der aus Bildpunktsignalen (106) zweier der weiteren Bildpunkte (117) bestimmt wird, die innerhalb des Umfelds (110) um den PDAF-Bildpunkt (112) in einer durch den PDAF-Bildpunkt (112) verlaufenden und senkrecht zu der ersten Richtung (101) orientierten Normalenrichtung (102, 105) beidseits des PDAF-Bildpunkts (112) angeordnet sind.

15. Verfahren (200) nach einem der Ansprüche 9 bis 14,
wobei die weiteren Bildpunkte (117), die zur Bestimmung der einzelnen Signaldifferenzwerte herangezogen werden, an Bildpunktpositionen eines Farbfilters des Bildsensors (100) angeordnet sind, deren Farbe einer Farbe der Bildpunktposition des PDAF-Bildpunkts (112) entspricht und/oder wobei die Signaldifferenzwerte aus Quadratwurzeln der zur Bestimmung der einzelnen Signaldifferenzwerte jeweils herangezogenen Bildpunktsignale (106) bestimmt werden.

16. Verfahren (200) nach einem der vorhergehenden Ansprüche,
wobei der PDAF-Bildpunkt (112) und der mindestens eine weitere PDAF-Bildpunkt (114) jeweils eine Blende (115) aufweisen, die den jeweiligen PDAF-Bildpunkt (112, 114) entlang einer senkrecht zu der ersten Richtung (101) orientierten Blendenkante (116) in einen freiliegenden Teil (119) und in einen abgedeckten Teil (118) teilt.

17. Verfahren (200) nach einem der vorhergehenden Ansprüche,

wobei der PDAF-Bildpunkt (112) und der weitere PDAF-Bildpunkt (114) innerhalb des Umfelds (110) an in der ersten Richtung (101) einander nächstgelegenen Bildpunktpositionen gleicher Farbe angeordnet sind und/oder
wobei der Bildsensor (100) eine Farbfiltermatrix umfasst, bei der alle Bildpunkte (112, 114, 117), die in der entlang der ersten Richtung (101) verlaufenden und die PDAF-Bildpunkte (112, 114) umfassenden PDAF-Bildpunktreihe (120) angeordnet sind, die gleiche Filterfarbe aufweisen.

18. Verfahren (200) nach einem der vorhergehenden Ansprüche,
wobei die Strukturrichtung als diejenige Richtung bestimmt wird, in der die abgebildete Bildstruktur (32) den geringsten Kontrast aufweist und entlang derer die Bildpunkte (112, 114, 117) des Bildsensors (100) folglich mit im Wesentlichen der gleichen Intensität

**19.** Sensoreinrichtung (1) mit einem optoelektronischen Bildsensor (100) und einer Auswerteeinrichtung (10) zur Erzeugung eines Ausgabesignals (11) eines PDAF-Bildpunkts (112) des optoelektronischen Bildsensors (100), wobei die Auswerteeinrichtung (10) dazu eingerichtet ist, das Ausgabesignal (11) des PDAF-Bildpunkts (112) unter Verwendung von Bildpunktsignalen (106) von in einem Umfeld (110) des PDAF-Bildpunkts (112) angeordneten weiteren Bildpunkten (117) des Bildsensors (100) zu erzeugen, wobei der Bildsensor (100) innerhalb des zur Erzeugung des Ausgabesignals (11) herangezogenen Umfelds (110) in einer entlang einer ersten Richtung (101) verlaufenden Bildpunktreihe den PDAF-Bildpunkt (112) und mindestens einen weiteren PDAF-Bildpunkt (114) aufweist,

wobei die Auswerteeinrichtung (10) dazu eingerichtet ist, Bildpunktsignale (106) der innerhalb des Umfelds (110) angeordneten Bildpunkte (117) des Bildsensors (100) zu erfassen und eine Strukturrichtung einer auf den Bildsensor (100) abgebildeten Bildstruktur (32) aus den Bildpunktsignalen (106) zumindest eines Teils der innerhalb des Umfelds (110) angeordneten Bildpunkte (112, 114, 117) zu bestimmen, wobei die Strukturrichtung als diejenige Richtung bestimmt wird, in der die abgebildete Bildstruktur (32) den geringsten Kontrast aufweist, wobei die Auswerteeinrichtung (10) dazu eingerichtet ist, das Ausgabesignal (11) des PDAF-Bildpunkts (112) in einem Fall als Interpolationssignal aus den Bildpunktsignalen (106) von innerhalb des Umfelds (110) angeordneten weiteren Bildpunkte (117) und in einem anderen Fall als verstärktes Signal durch Korrektur des Bildpunktsignals (106) des PDAF-Bildpunkts (112) mit einem Verstärkungsfaktor zu erzeugen, **gekennzeichnet dadurch, dass** die Auswerteeinrichtung (10) dazu eingerichtet ist, das Ausgabesignal (11) des PDAF-Bildpunkts (112) als das verstärkte Signal zu erzeugen, falls die Strukturrichtung um weniger als einen vorgegebenen Winkel von der ersten Richtung (101) abweicht.

**20.** Sensoreinrichtung (1) gemäß Anspruch 19, wobei die Strukturrichtung als diejenige Richtung bestimmt wird, in der die abgebildete Bildstruktur (32) den geringsten Kontrast aufweist und entlang derer die Bildpunkte (112, 114, 117) des Bildsensors (100) folglich mit im Wesentlichen der gleichen Intensität belichtet werden.

**21.** Kamera mit einer Sensoreinrichtung (1) gemäß einem der Ansprüche 19 und 20.

**Claims**

**1.** A method (200) of generating an output signal (11) of a PDAF pixel (112) of an optoelectronic image sensor (100)

using pixel signals (106) from further pixels (117) arranged in an environment (110) of the PDAF pixel (112), wherein, within the environment (110) used to generate the output signal (11), the image sensor (100) has the PDAF pixel (112) and at least one further PDAF pixel (114) in a pixel row extending along a first direction (101), wherein the method (200) comprises:

- detecting (201) pixel signals (106) of the pixels (112, 114, 117) of the image sensor (100) arranged within the environment (110);
- determining (225) a structure direction of an image structure (32) imaged onto the image sensor (100) from the pixel signals (106) of at least some of the pixels (117) arranged within the environment (110); and
- generating (240) the output signal (11) of the PDAF pixel (112),

wherein the structure direction is determined as that direction in which the imaged image structure (32) has the lowest contrast, wherein the output signal (11) of the PDAF pixel (112) is generated in one case as an interpolation signal from the pixel signals (106) of further pixels (117) arranged within the environment (110) and in another case as an amplified signal by correcting (230) the pixel signal (106) of the PDAF pixel (112) with an amplification factor, **characterized in that** the output signal (11) of the PDAF pixel (112) is generated as the amplified signal if the structure direction differs from the first direction (101) by less than a predefined angle.

**2.** A method (200) in accordance with claim 1, wherein the pixel signal (106) of the PDAF pixel (112) is corrected in order to generate the amplified signal in that only a signal portion of the pixel signal (106) of the PDAF pixel (112) exceeding a predefined dark signal of the PDAF pixel (112) is scaled by the amplification factor, and/or wherein the predefined angle amounts to at least 0°, at least 10°, or at least 13°, and/or at most 45°, at most 35°, or at most 23°, for example, 14°, 18° or 22.5°.

**3.** A method (200) in accordance with any one of the preceding claims, wherein the structure direction is determined from a first contrast value and a second contrast value of the imaged image structure (32), wherein the first contrast value specifies a contrast of the image structure (32) along the first direction (101) and the second contrast value specifies a contrast of the image structure (32) along a second direction (102) different from the first direction (101), for example along a second direction orthogonal to the first direction (101).

4. A method (200) in accordance with claim 3,

   wherein the first contrast value is generated taking into account a plurality of first pixel pairs (130) which each comprise two of the further pixels (117) that, within the environment (110), are arranged in first pixel rows (134) of the image sensor (100) extending along the first direction (101), and/or
   wherein the second contrast value is generated taking into account a plurality of second pixel pairs (140) which each comprise two of the further pixels (117) that, within the environment (110), are arranged in second pixel rows (144) of the image sensor (100) extending along the second direction (102).

5. A method (200) in accordance with claim 4, wherein each first pixel pair (130) consists of two further pixels (117) which each have the same color and/or each second pixel pair (140) consists of two further pixels (117) which each have the same color.

6. A method (200) in accordance with one of the claims 4 and 5,

   wherein the first contrast value comprises a sum of difference amounts of the pixel signals (106) of the further pixels (117) of the individual first pixel pairs (130), and/or
   wherein the second contrast value comprises a sum of difference amounts of the pixel signals (106) of the further pixels (117) of the individual second pixel pairs (140), and/or
   wherein an arrangement of the second pixel pairs (140) corresponds to an arrangement of the first pixel pairs (130) rotated from the first direction (101) about the PDAF pixel (112) in the second direction (102).

7. A method (200) in accordance with any one of the preceding claims, wherein the structure direction is determined from the pixel signals (106) of pixels (117) of different colors, and/or wherein the structure direction is determined while excluding the pixel signals (106) of the PDAF pixel (112) and of the further PDAF pixel (114).

8. A method (200) in accordance with any one of the preceding claims, wherein the output signal (11) of the PDAF pixel (112) is generated as the interpolation signal if the structure direction is oriented perpendicular to the first direction (101), preferably in all the cases in which the structure direction differs from the first direction (101) by more than the predefined angle.

9. A method (200) in accordance with any one of the preceding claims, wherein the method (200) comprises determining (210) at least two signal difference values,

   wherein the individual signal difference values are determined from pixel signals (106) of a respective two of the further pixels (117) that, within the environment (110) around the PDAF pixel (112), are arranged at both sides of the PDAF pixel (112) in further directions (102, 103, 104, 105) which extend through the PDAF pixel (112) and which are different in each case for the individual signal difference values, and
   wherein the interpolation signal is generated from the pixel signals (106) of those further pixels (117) which have the smallest signal difference value, wherein, for example, the further directions (102, 103, 104, 105) each differ from the first direction (101).

10. A method (200) in accordance with claim 9, wherein the interpolation signal is generated as a mean value of the pixel signals (106) of those further pixels (117) which have the smallest signal difference value, for example, as an arithmetic or weighted mean value.

11. A method (200) in accordance with one of the claims 9 to 10, wherein the signal difference values comprise a diagonal signal difference value which is determined from pixel signals (106) of two further pixels (117) that, within the environment (110) around the PDAF pixel (112), are arranged at both sides of the PDAF pixel (112) in a diagonal direction (103) extending through the PDAF pixel (112).

12. A method (200) in accordance with claim 11,

   wherein the diagonal signal difference is determined from the pixel signal (106) of two further pixels (117) which are equally far away from the PDAF pixel (112) in the diagonal direction (103) when both further pixels (117) that are equally far away are functional,
   wherein the diagonal signal difference is determined from pixel signals (106) of two further pixels (117) which are differently far away from the PDAF pixel (112) in the diagonal direction (103) when one of the further pixels (117) that are equally far away in the diagonal direction (103) is defective.

13. A method (200) in accordance with one of the claims 11 and 12,
    wherein the signal difference values comprise a further diagonal signal difference value which is determined from pixel signals (106) of two of the further pixels (117) that, within the environment (110) around the PDAF pixel (112), are arranged at both sides of the PDAF pixel (112) in a further diagonal direction (104) extending through the PDAF pixel (112) and oriented perpendicular to the diagonal direction (103).

14. A method (200) in accordance with any one of the claims 9 to 13,
    wherein the signal difference values comprise a perpendicular signal difference value which is determined from pixel signals (106) of two of the further pixels (117) that, within the environment (110) around the PDAF pixel (112), are arranged at both sides of the PDAF pixel (112) in a normal direction (102, 105) extending through the PDAF pixel (112) and oriented perpendicular to the first direction (101).

15. A method (200) in accordance with any one of the claims 9 to 14,

    wherein the further pixels (117) that are used to determine the individual signal difference values are arranged at pixel positions of a color filter of the image sensor (100) whose color corresponds to a color of the pixel position of the PDAF pixel (112), and/or
    wherein the signal difference values are determined from square roots of the respective pixel signals (106) used to determine the individual signal difference values.

16. A method (200) in accordance with any one of the preceding claims,
    wherein the PDAF pixel (112) and the at least one further PDAF pixel (114) each have a mask (115) which divides the respective PDAF pixel (112, 114) along a mask edge (116) oriented perpendicular to the first direction (101) into an uncovered portion (119) and a covered portion (118).

17. A method (200) in accordance with any one of the preceding claims, wherein, within the environment (110), the PDAF pixel (112) and the further PDAF pixel (114) are arranged at pixel positions of the same color disposed closest to one another in the first direction (101), and/or
    wherein the image sensor (100) comprises a color filter matrix in which all the pixels (112, 114, 117) that are arranged in the PDAF pixel row (120) extending along the first direction (101) and comprising the PDAF pixels (112, 114) have the same filter color.

18. A method (200) in accordance with any one of the preceding claims,
    wherein the structure direction is determined as that direction in which the imaged image structure (32) has the lowest contrast and along which the pixels (112, 114, 117) of the image sensor (100) are consequently exposed with substantially the same intensity.

19. A sensor device (1) comprising an optoelectronic image sensor (100) and an evaluation device (10) for generating an output signal (11) of a PDAF pixel (112) of the optoelectronic image sensor (100),

    wherein the evaluation device (10) is configured to generate the output signal (11) of the PDAF pixel (112) using pixel signals (106) from further pixels (117) of the image sensor (100) arranged in an environment (110) of the PDAF pixel (112), wherein, within the environment (110) used to generate the output signal (11), the image sensor (100) has the PDAF pixel (112) and at least one further PDAF pixel (114) in a pixel row extending along a first direction (101),
    wherein the evaluation unit (10) is configured to detect pixel signals (106) of the pixels (117) of the image sensor (100) arranged within the environment (110) and to determine a structure direction of an image structure (32) imaged onto the image sensor (100) from the pixel signals (106) of at least some of the pixels (112, 114, 117) arranged within the environment (110),
    wherein the structure direction is determined as that direction in which the imaged image structure (32) has the lowest contrast,
    wherein the evaluation device (10) is configured to generate the output signal (11) of the PDAF pixel (112) in one case as an interpolation signal from the pixel signals (106) of further pixels (117) arranged within the environment (110) and in another case as an amplified signal by correcting the pixel signal (106) of the PDAF pixel (112) with an amplification factor,
    **characterized in that**
    the evaluation device (10) is configured to generate the output signal (11) of the PDAF pixel (112) as the amplified signal if the structure direction differs from the first direction (101) by less than a predefined angle.

20. A sensor device (1) in accordance with claim 19,
    wherein the structure direction is determined as that direction in which the imaged image structure (32) has the lowest contrast and along which the pixels (112, 114, 117) of the image sensor (100) are consequently exposed with substantially the same intensity.

21. A camera comprising a sensor device (1) in accordance with one of the claims 19 and 20.

## Revendications

1. Procédé (200) de génération d'un signal de sortie (11) d'un pixel PDAF (112) d'un capteur d'images optoélectronique (100) en utilisant des signaux de pixels (106) d'autres pixels (117) disposés dans un champ ambiant (110) du pixel PDAF (112), le capteur d'images (100) présentant, à l'intérieur du champ ambiant (110) utilisé pour générer le signal de sortie (11), dans une rangée de pixels s'étendant le long d'une première direction (101), le pixel PDAF (112) et au moins un autre pixel PDAF (114), le procédé (200) comprenant:

   - acquérir (201) des signaux de pixels (106) des pixels (112, 114, 117) du capteur d'images (100) disposés à l'intérieur du champ ambiant (110),
   - déterminer (225) une direction de structure d'une structure d'image (32) imagée sur le capteur d'images (100) à partir des signaux de pixels (106) d'au moins une partie des pixels (117) disposés à l'intérieur du champ ambiant (110), et
   - générer (240) le signal de sortie (11) du pixel PDAF (112),

   dans lequel

   la direction de la structure est déterminée comme étant la direction dans laquelle la structure d'image (32) imagée présente le contraste le plus faible, le signal de sortie (11) du pixel PDAF (112) est généré, dans un cas, en tant que signal d'interpolation à partir des signaux de pixels (106) d'autres pixels (117) disposés à l'intérieur du champ ambiant (110) et, dans un autre cas, en tant que signal amplifié par correction (230) du signal de pixel (106) du pixel PDAF (112) avec un facteur d'amplification, **caractérisé en ce que** le signal de sortie (11) du pixel PDAF (112) est généré en tant que signal amplifié si la direction de la structure s'écarte de la première direction (101) d'un angle inférieur à un angle prédéterminé.

2. Procédé (200) selon la revendication 1,

   dans lequel, pour générer le signal amplifié, le signal de pixel (106) du pixel PDAF (112) est corrigé par mise à l'échelle avec le facteur d'amplification uniquement d'une partie de signal du signal de pixel (106) du pixel PDAF (112) dépassant un signal d'obscurité prédéterminé du pixel PDAF (112), et/ou
l'angle prédéterminé est de 0° au minimum, de 10° au minimum ou de 13° au minimum et/ou de 45° au maximum, de 35° au maximum ou de 23° au maximum, par exemple de 14°, 18° ou 22,5°.

3. Procédé (200) selon l'une des revendications précédentes,

   dans lequel la direction de la structure est déterminée à partir d'une première valeur de contraste et d'une deuxième valeur de contraste de la structure d'image (32) imagée,
   la première valeur de contraste spécifie un contraste de la structure d'image (32) le long de la première direction (101), et la deuxième valeur de contraste spécifie un contraste de la structure d'image (32) le long d'une deuxième direction (102) différente de la première direction (101), par exemple orthogonale à la première direction (101).

4. Procédé (200) selon la revendication 3,

   dans lequel la première valeur de contraste est générée en tenant compte d'une pluralité de premières paires de pixels (130) qui comprennent chacune deux des autres pixels (117) disposés à l'intérieur du champ ambiant (110) dans des premières rangées de pixels (134) du capteur d'images (100) s'étendant le long de la première direction (101),
   et/ou
   la deuxième valeur de contraste est générée en tenant compte d'une pluralité de deuxièmes paires de pixels (140) qui comprennent chacune deux des autres pixels (117) disposés à l'intérieur du champ ambiant (110) dans des deuxièmes rangées de pixels (144) du capteur d'images (100) s'étendant le long de la deuxième direction (102).

5. Procédé (200) selon la revendication 4,

   dans lequel chaque première paire de pixels (130) est constituée de deux autres pixels (117) qui présentent chacun la même couleur, et/ou
   chaque deuxième paire de pixels (140) est constituée de deux autres pixels (117) qui présentent chacun la même couleur.

6. Procédé (200) selon l'une des revendications 4 et 5,

dans lequel la première valeur de contraste comprend une somme de valeurs de différence des signaux de pixels (106) des autres pixels (117) des premières paires de pixels individuelles (130),

et/ou

la deuxième valeur de contraste comprend une somme de valeurs de différence des signaux de pixels (106) des autres pixels (117) des deuxièmes paires de pixels individuelles (140),

et/ou

une disposition des deuxièmes paires de pixels (140) correspond à une disposition des premières paires de pixels (130) tournée de la première direction (101) vers la deuxième direction (102) autour du pixel PDAF (112).

7. Procédé (200) selon l'une des revendications précédentes,

dans lequel la direction de la structure est déterminée à partir des signaux de pixels (106) de pixels (117) de différentes couleurs,

et/ou

la direction de la structure est déterminée en excluant les signaux de pixels (106) du pixel PDAF (112) et de l'autre pixel PDAF (114).

8. Procédé (200) selon l'une des revendications précédentes,

dans lequel le signal de sortie (11) du pixel PDAF (112) est généré en tant que signal d'interpolation si la direction de la structure est orientée perpendiculairement à la première direction (101), de préférence dans tous les cas où la direction de la structure s'écarte de la première direction (101) d'un angle supérieur à l'angle prédéterminé.

9. Procédé (200) selon l'une des revendications précédentes,

dans lequel le procédé (200) comprend déterminer (210) au moins deux valeurs de différence de signal,

les valeurs de différence de signal individuelles sont déterminées à partir de signaux de pixels (106) de deux pixels respectifs des autres pixels (117) disposés de part et d'autre du pixel PDAF (112) à l'intérieur du champ ambiant (110) autour du pixel PDAF (112) dans d'autres directions respectives (102, 103, 104, 105) qui passent par le pixel PDAF (112) et qui sont différentes pour les valeurs de différence de signal individuelles, et

le signal d'interpolation est généré à partir des signaux de pixels (106) des autres pixels (117) qui présentent la plus petite valeur de différence de signal,

par exemple, les autres directions (102, 103, 104, 105) diffèrent chacune de la première direction (101).

10. Procédé (200) selon la revendication 9, dans lequel le signal d'interpolation est généré en tant que valeur moyenne des signaux de pixels (106) des autres pixels (117) qui présentent la plus petite valeur de différence de signal, par exemple en tant que valeur moyenne arithmétique ou pondérée.

11. Procédé (200) selon l'une des revendications 9 à 10, dans lequel les valeurs de différence de signal comprennent une valeur de différence de signal diagonale déterminée à partir des signaux de pixels (106) de deux autres pixels (117) qui sont disposés de part et d'autre du pixel PDAF (112) à l'intérieur du champ ambiant (110) autour du pixel PDAF (112) dans une direction diagonale (103) passant par le pixel PDAF (112).

12. Procédé (200) selon la revendication 11,

dans lequel la différence de signal diagonale est déterminée à partir du signal de pixel (106) de deux autres pixels (117) équidistants du pixel PDAF (112) dans la direction diagonale (103), si les deux autres pixels (117) équidistants sont opérationnels,

la différence de signal diagonale est déterminée à partir de signaux de pixels (106) de deux autres pixels (117) situés à des distances différentes du pixel PDAF (112) dans la direction diagonale (103), si l'un des autres pixels (117) équidistants dans la direction diagonale (103) est défectueux.

13. Procédé (200) selon l'une des revendications 11 et 12,

dans lequel les valeurs de différence de signal comprennent une autre valeur de différence de signal diagonale déterminée à partir de signaux de pixels (106) de deux des autres pixels (117) disposés de part et d'autre du pixel PDAF (112) à l'intérieur du champ ambiant (110) autour du pixel PDAF (112) dans une autre direction diagonale (104) qui passe par le pixel PDAF (112) et qui est orientée perpendiculairement à la direction diagonale (103).

14. Procédé (200) selon l'une des revendications 9 à 13, dans lequel les valeurs de différence de signal comprennent une valeur de différence de signal verticale qui est déterminée à partir de signaux de pixels (106) de deux des autres pixels (117) disposés de part et d'autre du pixel PDAF (112) à l'intérieur du champ ambiant (110) autour du pixel PDAF (112) dans une direction normale (102, 105) qui passe par le pixel PDAF (112) et qui est orientée perpendiculairement à la première direction (101).

**15.** Procédé (200) selon l'une des revendications 9 à 14,

dans lequel les autres pixels (117) utilisés pour déterminer les valeurs de différence de signal individuelles sont disposés à des positions de pixels d'un filtre de couleur du capteur d'images (100) dont la couleur correspond à une couleur de la position de pixel du pixel PDAF (112), et/ou

les valeurs de différence de signal sont déterminées à partir des racines carrées des signaux de pixels (106) respectifs utilisés pour déterminer les valeurs de différence de signal individuelles.

**16.** Procédé (200) selon l'une des revendications précédentes,

dans lequel le pixel PDAF (112) et ledit au moins un autre pixel PDAF (114) comportent chacun un masque (115) qui, le long d'un bord de diaphragme (116) orienté perpendiculairement à la première direction (101), divise le pixel PDAF respectif (112, 114) en une partie découverte (119) et en une partie couverte (118).

**17.** Procédé (200) selon l'une des revendications précédentes,

dans lequel le pixel PDAF (112) et l'autre pixel PDAF (114) à l'intérieur du champ ambiant (110) sont situés à des positions de pixel de même couleur les plus proches l'une de l'autre dans la première direction (101), et/ou

le capteur d'images (100) comprend une matrice de filtres de couleur dans laquelle tous les pixels (112, 114, 117) situés dans la rangée de pixels PDAF (120) s'étendant le long de la première direction (101) et comprenant les pixels PDAF (112, 114) ont la même couleur de filtre.

**18.** Procédé (200) selon l'une des revendications précédentes,

dans lequel la direction de la structure est déterminée comme étant la direction dans laquelle la structure d'image (32) imagée présente le contraste le plus faible et le long de laquelle les pixels (112, 114, 117) du capteur d'images (100) sont donc exposés avec sensiblement la même intensité.

**19.** Dispositif capteur (1) comprenant un capteur d'images optoélectronique (100) et un dispositif d'évaluation (10) pour générer un signal de sortie (11) d'un pixel PDAF (112) du capteur d'images optoélectronique (100), dans lequel

le dispositif d'évaluation (10) est conçu pour générer le signal de sortie (11) du pixel PDAF (112) en utilisant des signaux de pixels (106) d'autres pixels (117) du capteur d'images (100) disposés dans un champ ambiant (110) du pixel PDAF (112),

le capteur d'images (100) présente, à l'intérieur du champ ambiant (110) utilisé pour générer le signal de sortie (11), dans une rangée de pixels s'étendant le long d'une première direction (101), le pixel PDAF (112) et au moins un autre pixel PDAF (114),

le dispositif d'évaluation (10) est conçu pour acquérir des signaux de pixels (106) des pixels (117) du capteur d'image (100) disposés à l'intérieur du champ ambiant (110) et pour déterminer une direction de structure d'une structure d'image (32) imagée sur le capteur d'images (100) à partir des signaux de pixels (106) d'au moins une partie des pixels (112, 114, 117) disposés à l'intérieur du champ ambiant (110),

la direction de la structure est déterminée comme étant la direction dans laquelle la structure d'image (32) imagée présente le contraste le plus faible, le dispositif d'évaluation (10) est conçu pour générer le signal de sortie (11) du pixel PDAF (112), dans un cas, en tant que signal d'interpolation à partir des signaux de pixels (106) d'autres pixels (117) disposés à l'intérieur du champ ambiant (110) et, dans un autre cas, en tant que signal amplifié par correction du signal de pixel (106) du pixel PDAF (112) avec un facteur d'amplification,

**caractérisé en ce que**

le dispositif d'évaluation (10) est conçu pour générer le signal de sortie (11) du pixel PDAF (112) en tant que signal amplifié si la direction de la structure s'écarte de la première direction (101) d'un angle inférieur à un angle prédéterminé.

**20.** Dispositif capteur (1) selon la revendication 19, dans lequel la direction de la structure est déterminée comme étant la direction dans laquelle la structure d'image (32) imagée présente le contraste le plus faible et le long de laquelle les pixels (112, 114, 117) du capteur d'images (100) sont donc exposés avec sensiblement la même intensité.

**21.** Caméra comprenant un dispositif capteur (1) selon l'une des revendications 19 et 20.

**Fig. 1**

**Fig. 2**

EP 4 049 445 B1

**Fig. 3**

**Fig. 4**

EP 4 049 445 B1

**Fig. 5**

Fig. 6

EP 4 049 445 B1

**Fig. 7**

# Fig. 8

Fig. 9

**Fig. 10**

EP 4 049 445 B1

**IN DER BESCHREIBUNG AUFGEFÜHRTE DOKUMENTE**

**In der Beschreibung aufgeführte Patentdokumente**

- US 2014267839 A1
- US 2019098240 A1
- US 2015319412 A1
- US 2012236185 A1